# EUROPÄISCHE PATENTSCHRIFT

(11) **EP 4 176 107 B1**
(45) Veröffentlichungstag und Bekanntmachung des Hinweises auf die Patenterteilung: **18.02.2026**
(21) Anmeldenummer: 21739290.1
(22) Anmeldetag: 24.06.2021
(51) Int. Cl.: C30B 23/02, C30B 29/36, C30B 23/06

(54) **KRISTALLZÜCHTUNGSANLAGE ZUR HERSTELLUNG EINES EINKRISTALLS**
CRYSTAL GROWING UNIT FOR PRODUCING A SINGLE CRYSTAL
UNITÉ DE CROISSANCE DE CRISTAL POUR PRODUIRE UN MONOCRISTAL

(30) Priorität: 03.07.2020 DE 102020117661
(43) Veröffentlichungstag der Anmeldung: 10.05.2023
(73) Patentinhaber: Friedrich-Alexander-Universität Erlangen-Nürnberg, 91054 Erlangen (DE)
(72) Erfinder: WELLMANN, Peter, 90425 Nürnberg (DE)
(74) Vertreter: Louis Pöhlau Lohrentz
(86) Internationale Anmeldenummer: PCT/EP2021/067312
(87) Internationale Veröffentlichungsnummer: WO 2022/002745

(56) Entgegenhaltungen:
- DE-A1- 102009 015 113
- DE-A1- 102014 217 956
- US-A1- 2011 217 224
- US-A1- 2011 305 622
- US-A1- 2013 171 403
- US-A1- 2019 323 145
- PETER J WELLMANN: "Review of SiC crystal growth technology", SEMICONDUCTOR SCIENCE TECHNOLOGY, IOP PUBLISHING LTD, GB, vol. 33, no. 10, 5 September 2018 (2018-09-05), pages 103001, XP020330720, ISSN: 0268-1242, [retrieved on 20180905], DOI: 10.1088/1361-6641/AAD831

## Beschreibung

Die Erfindung betrifft eine Kristallzüchtungsanlage umfassend einen Wachstumstiegel zur Herstellung eines Einkristalls. Die Kristallzüchtungsanlage ermöglicht insbesondere die Vergrößerung eines im Wachstumstiegel vorgesehenen Einkristalls. Weiterhin betrifft die Erfindung ein Verfahren zur Herstellung und/oder Vergrößerung eines Einkristalls in einem Wachstumstiegel einer Kristallzüchtungsanlage.

In der Praxis werden zahlreiche Einkristalle für die Anwendung in elektronischen Bauelementen oder zur Nutzung als Schmucksteine durch Verdampfen eines Quellenmaterials bei hohen Temperaturen und durch Abscheidung oder Kristallisation an einer etwas kälteren Stelle nach dem sogenannten PVT-Verfahren (englisch für "physical vapor transport") hergestellt.

Die Grundlagen zur Herstellung von Einkristallen aus Siliziumkarbid mittels des PVT-Verfahrens sind aus der wissenschaftlichen Veröffentlichung Yu. M. Tairov, V. F. Tsvetkov, Investigation of Growth Processes of Ingots of Silicon Carbide Single Crystals, Journal of Crystal Growth 43 (1978) 209 - 212 bekannt. Eine Übersicht zur aktuellen Forschung in Bezug auf die Herstellung von Einkristallen am Beispiel von Siliziumkarbid geht aus der wissenschaftlichen Veröffentlichung P. J. Wellmann, Review of SiC crystal growth technology, Semiconductor Science and Technology 33, 103001 hervor.

Aus der U.S.-amerikanischen Patentanmeldung US 2019 / 0 323 145 A1 ist eine Kristallzüchtungsanlage zur Herstellung von SiC-Einkristallen bekannt. Die bekannte Kristallzüchtungsanlage weist eine den Wachstumstiegel umgebende Isolierung mit unterschiedlichen Dickenbereichen auf.

Aus der U.S.-amerikanischen Patentanmeldung US 2011 / 217 224 A1 ist eine weitere Kristallzüchtungsanlage zur Herstellung von SiC-Einkristallen bekannt. Die bekannte Kristallzüchtungsanlage weist zum Abführen der Hitze aus dem ansonsten isolierten Wachstumstiegel an der Tiegeloberseite eine hohe Wärmeleitfähigkeit auf.

Damit der Kristallisationsprozess gleichmäßig abläuft, wird zwischen dem Quellenmaterial und dem wachsenden Einkristall ein axialer Temperaturgradient eingestellt. Dieser sorgt dafür, dass zum einen (i) das heißere Quellenmaterial verdampft und an kälterer Stelle am wachsenden Einkristall kristallisiert und dass zum anderen (ii) die Kristallisationswärme (= latente Wärme), die an der Kristallisationswachstumsfront freigesetzt wird, durch den wachsenden Einkristall abgeleitet wird. Gleichzeitig ist es wichtig, den radialen Temperaturgradienten möglichst klein zu halten. Ansonsten kommt es zu thermisch induzierten Verspannungen im wachsenden Einkristall. Diese Verspannungen führen zu einem Einbau von Versetzungen in den wachsenden Einkristall. Bei zu großen radialen Temperaturgradienten steigt also die Kristalldefektdichte im wachsenden Einkristall. Bei Verfahren nach dem Stand der Technik können die radialen Temperaturgradienten nur mit begrenzter Genauigkeit eingestellt werden. Dies führt insbesondere bei der Herstellung von großen Einkristallen zu Schwierigkeiten.

Aufgabe der vorliegenden Erfindung ist es, die Nachteile aus dem Stand der Technik zu beseitigen. Insbesondere soll eine Kristallzüchtungsanlage umfassend einen Wachstumstiegel und ein Verfahren angegeben werden, mit dem eine besonders gleichmäßige Temperaturverteilung senkrecht zur axialen Richtung einstellbar ist. Dadurch soll insbesondere die Qualität bei der Herstellung von großen Einkristallen verbessert werden.

Erfindungsgemäß wird diese Aufgabe durch eine Kristallzüchtungsanlage gemäß dem Gegenstand des Anspruchs 1 und durch ein Verfahren gemäß dem Gegenstand des Anspruchs 29 gelöst. Vorteilhafte Ausgestaltungen der Erfindung sind dazu in den abhängigen Ansprüchen angegeben.

Nach Maßgabe der Erfindung umfasst die Kristallzüchtungsanlage einen Wachstumstiegel zur Herstellung und/oder Vergrößerung eines Einkristalls. Die Herstellung und/oder Vergrößerung des Einkristalls erfolgt vorzugsweise durch das PVT-Verfahren. Der Wachstumstiegel ist vorzugsweise zylindrisch oder im Wesentlichen zylindrisch ausgeformt. Alternativ kann der Wachstumstiegel quaderförmig oder im Wesentlichen quaderförmig ausgeformt sein. Die Kristallzüchtungsanlage weist eine erste thermische Isolation mit einer ersten Wärmeleitfähigkeit und eine zweite thermische Isolation mit einer zweiten Wärmeleitfähigkeit auf. Das Vorsehen der ersten und zweiten thermischen Isolation ermöglicht vorteilhafterweise ein thermisches Isolieren des Wachstumstiegels, vorzugsweise ein einstellbares thermisches Isolieren des Wachstumstiegels. Bei der ersten thermischen Isolation handelt es sich vorzugsweise um eine thermisch hohe Isolation. Die erste thermische Isolation besteht vorzugsweise aus einem ersten Isolationsmaterial, insbesondere einem ersten Hochtemperaturisolationsmaterial. Dabei handelt es sich um einen Feststoff, z.B. Graphitfilz und/oder Graphitschaum. Bei der zweiten thermischen Isolation handelt es sich vorzugsweise um eine thermisch mittel-hohe Isolation. Die zweite thermische Isolation besteht vorzugsweise aus einem zweiten Isolationsmaterial, insbesondere einem zweiten Hochtemperaturisolationsmaterial. Dabei handelt es sich um einen Feststoff, z.B. Graphitschaum und/oder porösen Graphit. Der Wachstumstiegel weist einen Tiegelboden, eine Tiegelseitenwand und einen Tiegeldeckel auf. Der Tiegelboden kann als untere Tiegelwand, die Tiegelseitenwand als seitliche Tiegelwand und der Tiegeldeckel als obere Tiegelwand bezeichnet werden. Die Tiegelseitenwand ist mittelbar oder unmittelbar von der ersten thermischen Isolation umgeben. Vorzugsweise ist die Tiegelseitenwand mittelbar oder unmittelbar von der ersten thermischen Isolation vollständig umgeben. Vorzugsweise ist die erste thermische Isolation als Hohlzylinder ausgebildet. Die zweite thermische Isolation ist mittelbar oder unmittelbar oberhalb des Tiegeldeckels angeordnet. Vorzugsweise ist die zweite thermische Isolation als Vollzylinder oder im Wesentlichen als Vollzylinder ausgebildet. Vorzugsweise ist die zweite thermische Isolation radial von der ersten thermischen Isolation umgeben, insbesondere radial von der ersten thermischen Isolation vollständig umgeben. Besonders bevorzugt ist die zweite thermische Isolation dabei unmittelbar von der ersten thermischen Isolation umgeben. Dabei steht die zweite thermische Isolation vorzugsweise in direktem Kontakt mit der ersten thermischen Isolation. Nach Maßgabe der Erfindung ist die zweite Wärmeleitfähigkeit größer als die erste Wärmeleitfähigkeit.

Im Sinne der vorliegenden Anmeldung ist ein Gegenstand unmittelbar von einer Isolation umgeben, wenn kein weiterer Gegenstand zwischen dem Gegenstand und der Isolation liegt, insbesondere wenn sich der Gegenstand und die Isolation teilweise oder vollflächig berühren. Ein Gegenstand ist im Sinne der vorliegenden Anmeldung mittelbar von einer Isolation umgeben, wenn ein weiterer Gegenstand und/oder ein hinreichend großer Hohlraum zwischen dem Gegenstand und der Isolation liegt. Unter Hohlraum wird hier ein mit Luft und/oder Inertgas gefüllter Raum und/oder ein evakuierter Raum verstanden. Im Sinne der vorliegenden Anmeldung ist beispielsweise die Tiegelseitenwand mittelbar von der ersten thermischen Isolation umgeben, wenn eine Widerstandsheizeinheit zwischen der Tiegelseitenwand und der ersten thermischen Isolation angeordnet ist.

Die Erfindung macht sich zunutze, dass Größe und Richtung eines Wärmestroms aus einem heißen in ein kälteres Gebiet durch den Einsatz von Isolationsmaterialien mit unterschiedlicher Wärmeleitfähigkeit gesteuert werden können.

Durch die Erfindung wird vorteilhafterweise ein gleichmäßiger Wärmestrom in axialer Richtung realisiert. Durch Vorsehen der ersten und zweiten thermischen Isolation und durch entsprechende Einstellung der Heizleistung kann eine extrem gleichmäßige Temperaturverteilung senkrecht zur axialen Richtung eingestellt werden. Die bei einer Kristallisation von Materialien aus der Gasphase, aus der Schmelze oder aus der Lösung anfallende Kristallisationswärme kann gleichmäßig aus dem Wachstumstiegel abgeführt werden. Dadurch können thermisch induzierte Verspannungen im kristallisierten Material minimiert werden.

Vorteilhafterweise ist die Form der Wachstumsphasengrenze des wachsenden Einkristalls bezogen auf den Gasraum, das heißt vom Quellenmaterial aus betrachtet, leicht konvex. Dies wird vorzugsweise durch das Vorsehen von in gleicher Weise konvex gebogenen Isothermen innerhalb des Wachstumstiegels realisiert. Die Form der Isothermen wird durch den Wärmestrom gesteuert. Die grundlegenden Wärmeströme werden vorzugsweise durch (i) die geometrische Anordnung der Heizzonen (auf der Grundlagen der weiter unten erläuterten Widerstandsheizeinheiten und/oder induktiv eingekoppelte Heizzonen), (ii) den Aufbau des Wachstumstiegel, (iii) der umgebenden thermischen Isolation und/oder (iv) die kälteren Innenwände der Kristallzüchtungsanlage bestimmt.

Die Erfindung zielt darauf ab, den Wärmestrom aus der heißen Wachstumszelle heraus hin zur kühleren Umgebung räumlich zu lenken. Über die damit optimierte Temperaturverteilung werden die radialen Temperaturgradienten im kristallisierenden Material sehr klein gehalten und damit die thermisch induzierten Verspannungen in radialer Richtung reduziert. Durch eine definierte Einstellung des Wärmeabflusses kann auch der axiale Temperaturgradient auf ein Minimum reduziert werden.

Die Erfindung basiert auf einer definierten räumlichen Anordnung der den Wachstumstiegel umgebenden thermischen Isolation, welche aus mehreren Zonen unterschiedlicher Isolationseigenschaften, das heißt unterschiedlicher Wärmeleitfähigkeit, besteht. Dadurch kann der radiale Temperaturgradient auf einen Wert kleiner gleich 0,1 K/cm reduziert werden. Der dann noch vorhanden axiale Temperaturgradient kann durch Anpassung der zweiten thermischen Isolation in weiten Grenzen zwischen 0,1 K/cm bis mehr als 20 K/cm - unabhängig von den radialen Temperaturgradienten - definiert eingestellt werden.

Es hat sich gezeigt, dass die Wachstumsgeschwindigkeit und die Wachstumskinetik des Einkristalls, das heißt beispielsweise auch das Auftreten von Kristallbaufehlern, insbesondere von der Temperatur an der Oberfläche des Einkristalls abhängig ist. In Bereichen der Oberfläche des Einkristalls mit einer zu hohen Temperatur findet keine Anlagerung des gasförmigen Vorläufermaterials an den Einkristall statt. Bei einer zu niedrigen Temperatur findet eine zu schnelle Anlagerung des gasförmigen Vorläufermaterials statt, in deren Folge vermehrt Wachstumsfehler auftreten können.

Die Temperaturgradienten können durch das Vorsehen unterschiedlicher Wärmeleitfähigkeiten der umgebenden Isolationsmaterialien eingestellt werden. Das Vorsehen unterschiedlicher Wärmeleitfähigkeiten der umgebenden Isolationsmaterialien kann die Wärmeleitung und die Konvektion innerhalb des Wachstumstiegels beeinflussen. Die Wärmeleitung erfolgt dabei grundsätzlich durch alle Feststoffe, Flüssigkeiten und Gase. Sie kann durch das Fourier-Gesetz beschrieben werden. Die Konvektion wird durch sich bewegende Gase und Flüssigkeiten verursacht. Weiterhin kann das Vorsehen unterschiedlicher Wärmeleitfähigkeiten der umgebenden Isolationsmaterialien die Wärmeübertragung durch Strahlung innerhalb des Wachstumstiegels beeinflussen. Die Wärmeübertragung durch Strahlung ist insbesondere in Bezug auf den weiter unten beschrieben Hohlraum und in Bezug auf den weiter unten beschrieben Keimhohlraum von Bedeutung. Die Wärmeübertragung durch Strahlung wird bei der Kristallzüchtung typischerweise bei T > 500 °C signifikant und dominiert bei T > 1000 °C.

Mit Hilfe der Erfindung kann vorteilhafterweise die Temperatur an der Wachstumsgrenzfläche des Einkristalls in Abhängigkeit der Temperaturgradienten eingestellt werden. Diese Temperatur wird vorzugsweise auf einen Bereich von 1750°C bis 2500 °C, besonders bevorzugt auf einen Bereich von 1900°C bis 2300°C, eingestellt. Die Temperaturgradienten haben vorzugsweise einen Betrag von 0,1 K/cm bis 10 K/cm. Weiterhin kann mit Hilfe der Erfindung ein optimales Temperaturfeld und eine geeignete Gasphasenzusammensetzung für den Stofftransport bzw. den Materialstrom erzielt werden.

Mit Hilfe der Erfindung ist es vorteilhafterweise möglich, optimale Wärmeströme im Inneren des Wachstumstiegels gezielt einzustellen. Dadurch können Wachstumsfehler, wie z.B. Versetzungen, vermieden werden. Daher eignet sich das erfindungsgemäße Verfahren insbesondere für die Herstellung großer Einkristalle, beispielsweise Einkristalle mit einem Durchmesser von 150 mm, 200 mm, 250 mm, 300 mm oder mit einem noch größeren Durchmesser, insbesondere aus SiC oder AIN. Der Durchmesser des Einkristalls beträgt daher bei der erfindungsgemäßen Kristallzüchtungsanlage bzw. durch das erfindungsgemäße Verfahren vorzugsweise 100 mm bis 300 mm, besonders bevorzugt 150 mm, 200 mm, 250 mm oder 300 mm. Der Durchmesser des Wachstumstiegels übertrifft den Durchmesser des Einkristalls vorzugsweise um 1 mm bis 150 mm.

Die vorliegende Erfindung ist nicht auf das PVT-Verfahren beschränkt, sondern kann bei allen Gasphasenwachstumsprozessen zum Einsatz kommen. Die vorliegende Erfindung kann beispielsweise bei Prozessen zum Einsatz kommen, bei denen Gase als Präkursoren zugeführt werden. Die vorliegende Erfindung kann also z. B. bei der chemischen Gasphasenabscheidung (CVD) zum Einsatz kommen. Die Erfindung ist ebenfalls für die Anwendung bei der Kristallisation aus der Schmelze, beispielsweise nach den Verfahren "Bridgman" und "Vertical Gradient Freeze", von Bedeutung.

Nach einer vorteilhaften Ausgestaltung der Erfindung ist ein im Wachstumstiegel vorgesehenes Quellenmaterial aufheizbar, verdampfbar und abscheidbar.

Im Inneren des Wachstumstiegels ist weiterhin ein Einkristall angeordnet. Vorzugsweise sind das Quellenmaterial und der Einkristall an den beiden axial gegenüberliegenden Enden des Inneren des Wachstumstiegels angeordnet.

Dabei ist der Einkristall bevorzugt an einem oberen Ende des Inneren des Wachstumstiegels angeordnet. Mit Hilfe eines axialen Temperaturgradienten zwischen Quellenmaterial und Einkristall wird ein Wärmestrom und damit auch ein Materialstrom, das heißt ein Transport des verdampften Quellenmaterials zum Einkristall bereitgestellt. Vorteilhafterweise wird durch die vorliegende Erfindung ein gleichmäßiger Wärmestrom in axialer Richtung eingestellt.

Das Quellenmaterial besteht vorzugsweise aus dem gleichen Material wie der Einkristall. Zwischen dem Einkristall und dem Quellenmaterial befindet sich vorzugsweise ein Gasraum. Das Innere des Wachstumstiegels weist vorzugsweise eine zylindrische Form oder eine im Wesentlichen zylindrische Form auf. Das Quellenmaterial hat vorzugsweise eine im Wesentlichen zylindrische Form. Das Quellenmaterial hat dabei vorzugsweise einen Durchmesser, der dem Innendurchmesser des zylindrischen Wachstumstiegels entspricht. Das Quellenmaterial füllt also vorzugsweise den Wachstumstiegel in radialer Richtung vollständig aus. Der Einkristall hat vorzugsweise eine im Wesentlichen zylindrische Form, insbesondere die Form eines einseitig konvex abgerundeten Zylinders, wobei die konvex abgerundete Seite des Einkristalls dem Quellenmaterial zugewandt ist. Der Einkristall hat vorzugsweise einen Durchmesser, der im Wesentlichen dem Innendurchmesser des Wachstumstiegels entspricht. Der Einkristall kann dabei die Innenseite der Tiegelwand berühren. Alternativ kann der Einkristall ohne direkten Kontakt zur Tiegelwand hergestellt werden. Darüber hinaus kann der Einkristall von einem polykristallinen Ring umgeben sein. Der polykristalline Ring kann an der Innenseite der Tiegelwand anliegen.

Das Quellenmaterial kann insbesondere ein Karbid und/oder ein Nitrid umfassen. Vorzugsweise wird als Quellenmaterial Siliziumkarbid, bzw. als Formel geschrieben SiC, verwendet. Als Quellenmaterial ist vorzugsweise SiC, besonders bevorzugt ein SiC-Pulver und/oder ein SiC-Volumenkörper, vorgesehen. Der SiC-Volumenkörper kann insbesondere polykristallin sein.

Alternativ kann beispielsweise Aluminiumnitrid, das heißt AIN, als Quellenmaterial verwendet werden. Vorzugsweise kann dabei ein AIN-Pulver und/oder ein AIN-Volumenkörper, insbesondere ein polykristalliner AIN-Volumenkörper, vorgesehen sein.

Ein weiteres mögliches Quellenmaterial ist Zinkoxid (ZnO). Das Quellenmaterial wird vorzugsweise als Pulver und/oder als massiver Volumenkörper bereitgestellt. Der massive Volumenkörper kann insbesondere polykristallin sein.

Vorzugsweise wird ein zu vergrößernder Einkristall zunächst als Kristallkeim an dem Quellenmaterial gegenüberliegenden Ende des Inneren des Wachstumstiegels bereitgestellt. Anstelle des Begriffs "Kristallkeim" könnten auch die Begriffe Keimkristall und/oder Kristallisationskeim verwendet werden. Ausgehend vom Kristallkeim vergrößert sich der Einkristall im Laufe des erfindungsgemäßen Verfahrens durch Anlagerung von durch Verdampfen des Quellenmaterials erzeugtem gasförmigen Vorläufermaterial. Der Kristallkeim hat vorzugsweise einen Durchmesser, der 60 % bis 100 %, vorzugsweise 75 % bis 95 %, des Innendurchmessers des Wachstumstiegels entspricht. Für einen Durchmesser des Kristallkeims von 150 mm kann beispielsweise der Innendurchmesser des Wachstumstiegels 150 mm bis 200 mm betragen. Der Kristallkeim besteht vorzugsweise aus dem gleichen Material wie das Quellenmaterial. Bei der Verwendung von SiC als Quellenmaterial wird als Einkristall ein SiC-Einkristall gebildet. Vorzugsweise wird dabei zur Durchführung des erfindungsgemäßen Verfahrens zunächst ein SiC-Einkristall als Kristallkeim an dem Quellenmaterial gegenüberliegenden Ende des Inneren des Wachstumstiegels vorgesehen. Während der Durchführung des erfindungsgemäßen Verfahrens wird der SiC-Einkristall vergrößert. Dabei wächst der SiC-Einkristall vorzugsweise in axialer Richtung.

Bei der Verwendung von AIN als Quellenmaterial wird als Einkristall ein AIN-Einkristall gebildet. Vorzugsweise wird dabei zur Durchführung des erfindungsgemäßen Verfahrens zunächst ein AIN-Einkristall als Kristallkeim an dem Quellenmaterial gegenüberliegenden Ende des Inneren des Wachstumstiegels vorgesehen. Während der Durchführung des erfindungsgemäßen Verfahrens wird der AIN-Einkristall vergrößert. Dabei wächst der AIN-Einkristall vorzugsweise in axialer Richtung.

Alternativ kann der Kristallkeim aus einem anderen Material als das Quellenmaterial bestehen. Bei der Verwendung von AIN als Quellenmaterial kann beispielsweise als Kristallkeim alternativ ein SiC-Einkristall bereitgestellt werden.

Nach einer weiteren vorteilhaften Ausgestaltung der Erfindung ist die erste thermische Isolation zusätzlich mittelbar oder unmittelbar unterhalb des Tiegelbodens angeordnet, so dass die erste thermische Isolation vorzugsweise als unten geschlossener Hohlzylinder, insbesondere als nur unten geschlossener Hohlzylinder, ausgebildet ist. Anders betrachtet könnte die erste thermische Isolation als Zylinder mit einem nach oben geöffneten Sackloch bezeichnet werden. Die erste thermische Isolation hat also vorzugsweise die Form eines Bechers.

Nach einer weiteren vorteilhaften Ausgestaltung der Erfindung liegt die erste Wärmeleitfähigkeit in einem Bereich von 0,05 bis 5 W/(m*K), vorzugsweise in einem Bereich von 0,1 bis 2 W/(m*K), besonders bevorzugt bei 0,5 W/(m*K). Nach einer weiteren vorteilhaften Ausgestaltung der Erfindung liegt die zweite Wärmeleitfähigkeit in einem Bereich von 2 bis 50 W/(m*K), vorzugsweise in einem Bereich von 5 bis 20 W/(m*K), besonders bevorzugt bei 10 W/(m*K) liegt.

Nach einer weiteren vorteilhaften Ausgestaltung der Erfindung umfasst die Kristallzüchtungsanlage einen zwischen Tiegeldeckel und der zweiten thermischen Isolation angeordneten Hohlraum. Die Oberfläche der ersten thermischen Isolation kann mittelbar oder unmittelbar an den Hohlraum angrenzen. Die Oberfläche der zweiten thermischen Isolation kann mittelbar oder unmittelbar an den Hohlraum angrenzen.

Der Hohlraum ist vorzugsweise mit einem Inertgas, insbesondere mit Argon, gefüllt. Alternativ enthält der Hohlraum ein Vakuum. Der Druck innerhalb des Hohlraums beträgt vorzugsweise zwischen 1 und 1000 mbar.

Der Hohlraum ist vorzugsweise oben durch die untere Oberfläche der zweiten thermischen Isolation, unten durch die obere Oberfläche des Tiegeldeckels und seitlich durch die innere Oberfläche der ersten thermischen Isolation begrenzt. Der Tiegeldeckel ist vorzugsweise aus dichtem Graphit gebildet. Die erste thermische Isolation ist vorzugsweise aus Graphitfilz oder Graphitschaum gebildet. Die zweite thermische Isolation ist vorzugsweise aus Graphitschaum oder poröser Graphit gebildet.

Alternativ dazu können die an den Hohlraum angrenzenden Oberflächen auch durch den Tiegeldeckel und durch einen auf dem Tiegeldeckel aufgebrachten Hohlzylinder, vorzugsweise einen Graphithohlzylinder, gebildet werden. Dieser weist eine stabilisierende mechanische Funktion auf. Dadurch wird dem Hohlraum also eine größere mechanische Stabilität verliehen. Die an den Hohlraum mittelbar angrenzende Oberfläche der ersten thermischen Isolation und die an den Hohlraum mittelbar angrenzende Oberfläche der zweiten thermischen Isolation sind in dieser Ausgestaltung also vom Hohlzylinder, vorzugsweise vom Graphithohlzylinder, verkleidet. Vorzugsweise kann der Hohlraum seitlich durch einen Graphithohlzylinder und/oder oben durch eine Graphitscheibe begrenzt werden. Die Wandstärke des Graphithohlzylinders bzw. die Dicke der Graphitscheibe liegt vorzugsweise zwischen 1 mm und 30 mm, besonders bevorzugt in einem Bereich zwischen 5 mm und 15 mm.

Durch Vorsehen des Hohlraums kann der Wärmeübergang bzw. der Wärmestrom aus dem Wachstumstiegel über den Tiegeldeckel in die zweite thermische Isolation vorteilhafterweise weiter optimiert werden. Dadurch können im Kristallwachstumsraum ideale Wachstumsbedingungen in Bezug auf die absolute Temperatur und die axialen und radialen Temperaturgradienten realisiert werden.

Nach einer weiteren vorteilhaften Ausgestaltung der Erfindung weist die an den Hohlraum angrenzende Oberfläche der ersten thermischen Isolation einen vorbestimmten ersten Emissionsgrad (ε), und/oder die an den Hohlraum angrenzende Oberfläche der zweiten thermischen Isolation einen vorbestimmten zweiten Emissionsgrad (ε) und/oder die an den Hohlraum angrenzende Oberfläche des Tiegeldeckels einen vorbestimmten dritten Emissionsgrad (ε) auf. In der oben genannten alternativen Ausgestaltung können die Emissionsgrade (ε) des Hohlzylinders, vorzugsweise des Graphithohlzylinders und/oder der Graphitscheibe, entsprechend angepasst werden. Bei dieser alternativen Ausgestaltung weist vorzugsweise die an den Hohlraum angrenzende Oberfläche des die erste thermische Isolation verkleidenden Graphithohlzylinders den vorbestimmten ersten Emissionsgrad (ε), und/oder die an den Hohlraum angrenzende Oberfläche der die zweite thermische Isolation verkleidenden Graphitscheibe den vorbestimmten zweiten Emissionsgrad (ε) auf. Die an den Hohlraum angrenzende Oberfläche des Tiegeldeckels weist auch bei dieser alternativen Ausgestaltung vorzugsweise den vorbestimmten dritten Emissionsgrad (ε) auf.

Der erste, zweite und/oder dritte Emissionsgrad (ε) können übereinstimmen. Alternativ können sich der erste, zweite und/oder dritte Emissionsgrad (ε) unterscheiden.

Der erste, zweite und/oder dritte Emissionsgrad (ε) ist vorzugsweise auf einen Bereich von zwischen 0,6 und 0,9 eingestellt. Durch den Wärmestrahlungsaustausch der sich gegenüberliegenden Oberflächen, insbesondere der oberen Oberfläche des Tiegeldeckels und der unteren Oberfläche der zweiten thermischen Isolation, werden die Oberflächentemperaturen dieser sich gegenüberliegenden Oberflächen homogenisiert. Dies hat zur Folge, dass der Wärmeabfluss aus dem Wachstumstiegel nach oben noch stärker axial ausgerichtet ist. Der Temperaturgradient weist also höchstens eine kleine radiale Komponente auf. Vorzugsweise kann der radiale Temperaturgradient auf einen Wert kleiner gleich 0,1 K/cm reduziert werden. Dadurch werden vorteilhafterweise leicht konvexe Isothermen an der Kristallwachstumsfront bewirkt. Somit werden vorteilhafterweise günstige Wachstumsbedingungen für den wachsenden Einkristall erreicht.

In der oben beschriebenen Ausgestaltung mit einem zusätzlichen Vorsehen eines Graphithohlzylinders und/oder einer Graphitscheibe wird die Oberflächentemperaturverteilung der einzelnen Oberflächen aufgrund der hohen Wärmeleitung der Graphitwände zusätzlich zum oben beschriebenen Wärmestrahlungsaustausch homogenisiert.

Alternativ ist der erste, zweite und/oder dritte Emissionsgrad (ε) vorzugsweise auf einen Bereich von zwischen 0,05 und 0,5, besonders bevorzugt auf einen Bereich zwischen 0,2 und 0,4, insbesondere auf etwa 0,3 eingestellt.

Die Oberfläche der ersten thermischen Isolation, die Oberfläche der zweiten thermischen Isolation, und/oder die Oberfläche des Tiegeldeckels können mit einer Beschichtung versehen sein. Durch die Beschichtung kann insbesondere ein niedriger Emissionsgrad (ε) an den entsprechenden Oberflächen vorgesehen sein. Durch die Beschichtung mit TaC kann beispielsweise ein Emissionsgrad ε von etwa 0,3 vorgesehen werden. Die Beschichtung insbesondere der Oberfläche der zweiten thermischen Isolation und der Oberfläche des Tiegeldeckels wirkt sich vorteilhafterweise besonders stark auf den axialen Temperaturgradienten im Hohlraum aus. Die thermischen Gradienten im Kristallwachstumsraum bleiben davon vorteilhafterweise weitgehend unberührt. Das Aufbringen von Beschichtungen mit niedrigem Emissionsgrad ε führt vorteilhafterweise zu einem erhöhten axialen Temperaturgradienten im Hohlraum. Ein erhöhter axialer Temperaturgradient im Hohlraum wird physikalisch von einem reduzierten Wärmestrom aus dem Wachstumstiegel begleitet. In der Summe führt dies vorteilhafterweise dazu, dass im Tiegelinneren die gleichen thermischen Bedingungen erreicht werden können, wie es beim Verzicht auf die Beschichtung der an den Hohlraum angrenzenden Oberflächen möglich ist, allerdings bei einer um 10 % bis 20% niedrigeren Heizleistung. Auf diese Weise kann die Beschichtung zum Einsparen von elektrischer Energie genutzt werden.

Vorzugsweise ist die Oberfläche der zweiten thermischen Isolation bzw. der die zweite thermische Isolation verkleidenden Graphitscheibe und die Oberfläche des Tiegeldeckels mit einer Beschichtung versehen. Eine Beschichtung der seitlich den Hohlraum begrenzenden ersten thermischen Isolation scheint sich nur wenig auf den radialen Temperaturgradienten auszuwirken. Dies ist unabhängig vom Vorsehen eines niedrigen oder hohen Emissionsgrads (ε) und hat anscheinend keinen nennenswerten Einfluss auf die Temperaturgradienten im Wachstumstiegel.

Vorzugsweise stimmen zumindest der zweite und der dritte Emissionsgrad (ε) überein. Bei einem Vorsehen einer Beschichtung von niedrigem Emissionsgrad (ε) (z.B. mit TaC, ε = ca. 0,3) sowohl an der oberen Oberfläche des Tiegeldeckels als auch an der unteren Oberfläche der zweiten thermischen Isolation wird besonders bevorzugt, auch die innere Oberfläche der ersten thermischen Isolation auf die gleiche Weise zu beschichten. Dadurch werden abrupte Übergänge in den Eckbereichen beim Übergang von niedrigem zu hohem Emissionsgrad (ε) und damit einhergehende singuläre Wärmeübertragungsspitzen vorteilhafterweise verhindert. Entsprechende Überlegungen gelten auch beim Vorsehen eines hohen Emissionsgrads (ε) sowohl an der oberen Oberfläche des Tiegeldeckels als auch an der unteren Oberfläche der zweiten thermischen Isolation zum Verhindern eines Übergangs von hohem zu niedrigem Emissionsgrad (ε) in den Eckbereichen.

Bei einem Graphithohlzylinder und/oder einer Graphitscheibe kann durch Aufrauen beispielsweise ein Emissionsgrad ε=0,9, durch Polieren beispielsweise ein Emissionsgrad ε=0,6 oder durch Beschichten, insbesondere durch Beschichten mit TaC, beispielsweise ein Emissionsgrad ε=0,3 vorgesehen werden. Es ergeben sich jeweils auch die oben genannten Vorteile.

Bevorzugte Kombinationen aus zweitem und drittem Emissionsgrad (ε) und die sich daraus ergebende Auswirkung auf den axialen Temperaturgradienten zeigt die folgende Tabelle:

| | | | | |
|---|---|---|---|---|
| **dritter Emissionsgrad** | ε = 0,6 bis 0,9 | ε = 0,6 bis 0,9 | ε = 0,1 bis 0,5 | ε = 0,1 bis 0,5 |
| **zweiter Emissionsgrad** | ε = 0,6 bis 0,9 | ε = 0,1 bis 0,5 | ε = 0,6 bis 0,9 | ε = 0,1 bis 0,5 |
| **axialer Temperaturgradient** | klein | mittel | mittel | groß |

Nach einer weiteren vorteilhaften Ausgestaltung der Erfindung weist die an den Hohlraum angrenzende Oberfläche des Tiegeldeckels und/oder die an den Hohlraum angrenzende Oberfläche der ersten thermischen Isolation und/oder die an den Hohlraum angrenzende Oberfläche der zweiten thermischen Isolation ein vorbestimmtes Relief auf. Eine mit dem vorbestimmten Relief versehene Oberfläche bzw. mehrere mit dem vorbestimmten Relief versehene Oberflächen kann/können außerdem wie oben erläutert einen vorbestimmten Emissionsgrad (ε) aufweisen, beispielsweise durch eine Beschichtung. Beispielsweise kann die zusätzlich mit einem Relief versehene obere Oberfläche des Tiegeldeckels mit einer Beschichtung mit niedrigem Emissionsgrad (ε) versehen sein, z.B. mit TaC mit einem Emissionsgrad ε von etwa 0,3.

Über die Einstellung des axialen Temperaturgradienten durch Variation des Emissionsgrads ε der Oberflächen hinaus, ermöglicht die Aufprägung eines Reliefs vorteilhafterweise die Einflussnahme auf die Richtung der Wärmestrahlung und damit auf den radialen Temperaturgradienten innerhalb des Hohlraums. Damit wird in kleinem Maß vorteilhafterweise auch auf das Temperaturfeld im Wachstumstiegel, also im Bereich des wachsenden Einkristalls, Einfluss genommen. Dies ist für das Fine-Tuning des Temperaturfelds im Wachstumstiegel von Bedeutung. Dadurch kann vorteilhafterweise ein kleiner radialer Temperaturgradient mit zugehörigen leicht konvex verlaufenden Isothermen an der Kristallwachstumsfront definiert eingestellt werden. Dadurch kann vorteilhafterweise verhindert werden, dass das Temperaturfeld ausgehend von einem radialen Temperaturgradienten nahe 0 K/cm durch unbeabsichtigte Variationen in den Materialeigenschaften oder Geometrien versehentlich in leicht konkave Isothermen an der Kristallwachstumsfront umschlägt, was den massiven Einbau von Kristallbaufehlern zur Folge hätte. Vorteilhafterweise kann also durch Vorsehen von leicht konvex verlaufenden Isothermen an der Kristallwachstumsfront das Kristallwachstum bei einer niedrigen Kristalldefektdichte stabilisiert werden.

Nach einer weiteren vorteilhaften Ausgestaltung der Erfindung ist der Einkristall mit Hilfe einer Keimeinhängevorrichtung angeordnet. Der Name Keimeinhängevorrichtung erklärt sich dadurch, dass zu Beginn des Verfahrens der Einkristall als Kristallkeim mit Hilfe der Keimeinhängevorrichtung angeordnet wird. Bekanntlich vergrößert sich der Einkristall im Laufe des Verfahrens ausgehend vom Kristallkeim durch Anlagerung von gasförmigem Quellenmaterial. Daher wird im Rahmen der vorliegenden Anmeldung unter dem Begriff Einkristall auch der Kristallkeim verstanden. In der weiteren vorteilhaften Ausgestaltung der Erfindung umfasst die Kristallzüchtungsanlage einen zwischen dem Einkristall und dem Tiegeldeckel innerhalb des Wachstumstiegels angeordneten Keimhohlraum. Der Keimhohlraum ist vorzugsweise durch die innere Oberfläche der Keimeinhängevorrichtung, die untere Oberfläche des Tiegeldeckels und die obere Oberfläche des Einkristalls begrenzt.

Der Keimhohlraum ist vorzugsweise mit einem Inertgas, insbesondere mit Argon, gefüllt. Alternativ enthält der Keimhohlraum ein Vakuum. Der Druck innerhalb des Keimhohlraums beträgt vorzugsweise zwischen 1 und 1000 mbar.

Die Keimeinhängevorrichtung kann aus Graphit gebildet sein. Durch Vorsehen der Keimeinhängevorrichtung kann der wachsende Einkristall mechanisch vom Wachstumstiegel getrennt werden. Dadurch können thermisch induzierte mechanische Spannungen im Einkristall vermieden werden, wie sie ansonsten bei einem in herkömmlicher Weise am Wachstumstiegel befestigten Einkristall aufgrund der unterschiedlichen thermischen Ausdehnungskoeffizienten des Einkristalls und des aus Graphit gebildeten Wachstumstiegels bzw. des in der Regel aus dichtem Graphit gebildeten herkömmlichen Keimträgers auftreten könnten.

Nach einer weiteren vorteilhaften Ausgestaltung der Erfindung weist die an den Keimhohlraum angrenzende Oberfläche der Keimeinhängevorrichtung einen vorbestimmten vierten Emissionsgrad (ε), und/oder die an den Keimhohlraum angrenzende Oberfläche des Tiegeldeckels einen vorbestimmten fünften Emissionsgrad (ε) und/oder die an den Keimhohlraum angrenzende Oberfläche des Einkristalls einen vorbestimmten sechsten Emissionsgrad (ε) auf. Die an den Keimhohlraum angrenzende Oberfläche der Keimeinhängevorrichtung und/oder die an den Keimhohlraum angrenzende Oberfläche des Tiegeldeckels und/oder die an den Keimhohlraum angrenzende Oberfläche des Einkristalls können dazu mit einer Beschichtung versehen sein. Bei der Beschichtung kann es sich um C, das heißt um Kohlenstoff oder Graphit, um TaC und/oder um eine pyrolytische Beschichtung mit Kohlenstoff (PyC) handeln. Durch eine Beschichtung mit C, das heißt mit Kohlenstoff oder Graphit, kann der Emissionsgrad (ε) vorzugsweise auf 0,9 eingestellt werden. Durch eine Beschichtung mit TaC kann der Emissionsgrad (ε) vorzugsweise auf 0,3 eingestellt werden. Durch eine pyrolytische Beschichtung mit Kohlenstoff (PyC) kann der Emissionsgrad (ε) vorzugsweise auf 0,6 eingestellt werden.

Der vierte, fünfte und/oder sechste Emissionsgrad (ε) können übereinstimmen. Alternativ können sich der vierte, fünfte und/oder sechste Emissionsgrad (ε) unterscheiden.

Die insbesondere durch Vorsehen einer der oben genannten Beschichtungen eingestellte Höhe Emissionsgrads (ε), insbesondere des fünften und/oder sechsten Emissionsgrads (ε), nimmt vorteilhafterweise Einfluss auf den axialen Temperaturgradienten im Keimhohlraum. Das Aufbringen von Beschichtungen mit niedrigem Emissionsgrad (ε) führt vorteilhafterweise zu einem erhöhten axialen Temperaturgradienten im Keimhohlraum. Ein erhöhter axialer Temperaturgradient im Keimhohlraum führt vorteilhafterweise zu einer höheren Übersättigung der Wachstumsspezies an der Wachstumsfront des wachsenden Einkristalls. Eine solche Übersättigung ist vorteilhaft bei der Herstellung von SiC mit kubischem Polytyp, das heißt bei der Herstellung von 3C-SiC.

Im Gegensatz dazu führt das Aufbringen von Beschichtungen mit hohem Emissionsgrad (ε) vorteilhafterweise zu einem verringerten axialen Temperaturgradienten im Keimhohlraum. Ein verringerter axialer Temperaturgradient im Keimhohlraum führt vorteilhafterweise zu einer geringen Übersättigung der Wachstumsspezies an der Wachstumsfront des wachsenden Einkristalls. Das ist vorteilhaft bei der Herstellung von SiC mit hexagonalem Polytyp, beispielsweise bei der der Herstellung von 6H-SiC und insbesondere bei der der Herstellung von 4H-SiC.

Im Fall der Herstellung eines Einkristalls aus SiC hängt der bevorzugte Wertebereich des vorbestimmten vierten, fünften und sechsten Emissionsgrads (ε) also unter anderem von der Art des gewünschten Polytyps ab.

Eine Übersicht über verschiedene Kombinationen des fünften und sechsten Emissionsgrads (ε) und dem resultierenden Temperaturgradient zeigt die folgende Tabelle. Dabei ist jeweils in Klammer die Art der bevorzugten Beschichtung zur Erreichung des genannten Emissionsgrads (ε) angegeben.

| | | | | | | | |
|---|---|---|---|---|---|---|---|
| **sechster Emissionsgrad** | ε = 0,9 (C) | ε = 0,3 (TaC) | ε = 0,6 (PyC) | ε = 0,9 (C) | ε = 0,3 (TaC) | ε = 0,6 (PyC) | ε = 0,6 (PyC) |
| **fünfter Emissionsgrad** | ε = 0,9 (C) | ε = 0,3 (TaC) | ε = 0,6 (PyC) | ε = 0,3 (TaC) | ε = 0,9 (C) | ε = 0,3 (TaC) | ε = 0,9 (C) |
| **axialer Temperaturgradient** | klein | groß | mittel | groß | groß | groß | mittel |

Nach einer weiteren vorteilhaften Ausgestaltung der Erfindung weist die an den Keimhohlraum angrenzende Oberfläche des Tiegeldeckels und/oder die an den Keimhohlraum angrenzende Oberfläche der Keimeinhängevorrichtung und/oder die an den Keimhohlraum angrenzende Oberfläche des Einkristalls ein vorbestimmtes weiteres Relief auf. Durch das Vorsehen des weiteren Reliefs wird vorzugsweise Einfluss auf den radialen Temperaturgradienten im Keimhohlraum und/oder im Gasraum des Wachstumstiegels genommen. Insbesondere kann beispielsweise ein kleiner radialer Temperaturgradient mit zugehörigen leicht konvex verlaufenden Isothermen an der Kristallwachstumsfront des wachsenden Einkristalls 4 definiert eingestellt werden. Dadurch kann vorteilhafterweise verhindert werden, dass das Temperaturfeld ausgehend von einem radialen Temperaturgradienten nahe 0 K/cm durch unbeabsichtigte Variationen in den Materialeigenschaften oder Geometrien versehentlich in leicht konkave Isothermen an der Kristallwachstumsfront umschlägt, was den massiven Einbau von Kristallbaufehlern zur Folge hätte. Vorteilhafterweise kann also durch Vorsehen von leicht konvex verlaufenden Isothermen an der Kristallwachstumsfront das Kristallwachstum bei einer niedrigen Kristalldefektdichte stabilisiert werden.

Nach einer weiteren vorteilhaften Ausgestaltung der Erfindung ist der Keimhohlraum mit einem Feststoff ausgefüllt. Der Feststoff besteht aus SiC-Pulver, aus einem polykristallinen oder einkristallinen SiC-Kristall, und/oder aus porösem oder massivem Graphit. Der Feststoff ist vorzugsweise ein temperaturstabiles und mit SiC chemisch inertes Material. Der Feststoff ist vorzugsweise derart vorgesehen, dass er den Abtransport der Wärme vom Einkristall zum Tiegeldeckel nicht behindert. Vorteilhafterweise wird durch das Vorsehen des Feststoffs im Keimhohlraum eine weitere Möglichkeit bereitgestellt, einen definierten Abtransport der Kristallisationswärme zu gewährleiten.

Nach einer weiteren vorteilhaften Ausgestaltung der Erfindung umfasst die Kristallzüchtungsanlage eine Heizvorrichtung zum Aufheizen des Wachstumstiegels, insbesondere zum Aufheizen des Quellenmaterials und/oder des Einkristalls. Die Heizvorrichtung umfasst vorzugsweise eine oder mehrere induktive Heizeinheiten und/oder eine oder mehrere Widerstandsheizeinheiten.

Eine induktive Heizeinheit wird vorzugsweise mit einer Spule gebildet. Die Spule kann außerhalb der ersten thermischen Isolation vorgesehen sein. Beim Vorsehen einer induktiven Heizeinheit ist vorzugsweise der Wachstumstiegel, insbesondere die Tiegelseitenwand des Wachstumstiegels elektrisch leitfähig. Der Wärmeeintrag erfolgt bei der induktiven Heizeinheit vorzugsweise über die Tiegelseitenwand. Anders ausgedrückt ist vorzugsweise die Tiegelseitenwand selbst die Heizzone.

Weiterhin kann ein elektrisch leitfähiger Suszeptor als Teil der Heizvorrichtung zwischen der Tiegelseitenwand und der ersten thermischen Isolation angeordnet sein. Der Suszeptor kann einen materialfreien Bereich umfassen. Der Suszeptor dient zur primären Aufnahme der mittels der induktiven Heizeinheit erzeugten Induktionsleistung. Der Suszeptor ist beispielsweise aus Graphit gebildet. Der materialfreie Bereich enthält beispielsweise ein Vakuum oder ein Gas. Durch Vorsehen des Suszeptors 31 kann vorteilhafterweise die Aufnahme der Induktionsleistung verbessert werden. Die induktive Heizeinheit ist vorzugsweise in einem Frequenzbereich zwischen 3 und 50 kHz, besonders bevorzugt zwischen 5 und 20 kHz, betreibbar.

Die Widerstandsheizeinheit ist vorzugsweise mit Graphitheizelementen ausgestaltet. Die Graphitheizelemente bilden vorzugsweise eine Heizwicklung außen um die Tiegelseitenwand des Wachstumstiegels. Dabei ist eine mäanderförmige Ausführung der Heizwicklung besonders bevorzugt. Beim Vorsehen einer Widerstandsheizeinheit ist die erste thermische Isolation vorzugsweise außen um die Widerstandsheizeinheit herum vorgesehen.

Die induktive Heizeinheit und die Widerstandsheizeinheit können miteinander kombiniert werden. Vorzugsweise kann also sowohl eine induktive Heizeinheit als auch eine Widerstandsheizeinheit vorgesehen sein. Dabei umgibt vorzugsweise die Widerstandsheizeinheit die Tiegelseitenwand, die erste thermische Isolation die Widerstandsheizeinheit und die induktive Heizeinheit die erste thermische Isolation. Vorzugsweise umgibt dabei die Widerstandsheizeinheit unmittelbar die Tiegelwand, und/oder die erste thermische Isolation unmittelbar die Widerstandsheizeinheit, und/oder die induktive Heizeinheit unmittelbar die erste thermische Isolation.

Nach einer weiteren vorteilhaften Ausgestaltung der Erfindung ist die Heizvorrichtung zwischen dem Tiegelboden und der ersten thermischen Isolation und/oder zwischen der Tiegelseitenwand und der ersten thermischen Isolation angeordnet. Dadurch ist es möglich, verschiedene Heizzonen auszubilden. Die zwischen dem Tiegelboden und der ersten thermischen Isolation angeordnete Heizvorrichtung wird vorzugsweise als Widerstandsheizeinheit ausgestaltet.

Durch eine Beheizung unterhalb des Tiegelbodens, das heißt zwischen dem Tiegelboden und der ersten thermischen Isolation und das Vorsehen der zweiten thermischen Isolation oberhalb des Tiegeldeckels wird der Wärmestrom in axialer Richtung durch den Wachstumstiegel und durch den wachsenden Einkristall geführt.

Mit Hilfe einer Beheizung an der Tiegelseitenwand kann die mittlere Temperatur des Wachstumstiegels auf einen definierten Wert gebracht werden. Gleichzeitig wird dadurch auch ein kleiner radialer Temperaturgradient im Bereich des wachsenden Einkristalls aufgeprägt, dessen Größe durch das Verhältnis der Wärmeströme aus der unteren und/oder seitlichen Beheizung variiert werden kann. Dieser kleine radiale Temperaturgradient führt zur Ausprägung von (vom Quellenmaterial aus betrachtet) leicht konvex verlaufenden Isothermen und entsprechend dazu von einer leicht konvex verlaufenden Kristallwachstumsphasengrenze.

Weiterhin wird durch die Beheizung der Tiegelseitenwand eine aus dem Wachstumstiegel radial nach außen gerichtete Komponente des Wärmestroms, das heißt ein Abtransport der Wärme aus dem Wachstumstiegel durch die Tiegelseitenwand, der sich aufgrund der nicht unendlich hohen Isolationseigenschaft der den Wachstumstiegel seitlich umgebenden ersten thermischen Isolation ergeben würde, überkompensiert. Dadurch werden vorteilhafterweise die Ausprägung von (vom Quellenmaterial aus betrachtet) konkaven Isothermen und entsprechend dazu von einer konkave Kristallwachstumsphasengrenze mit für das Kristallwachstum negativen Effekten verhindert.

Durch Kombination der Beheizung von unten und von der Seite und die definierte Auswahl der zweiten thermischen Isolation können vorteilhafterweise die mittlere Temperatur und der axiale Temperaturgradient bei minimalem radialen Temperaturgradient definiert eingestellt werden.

Bevorzugte Beheizungskombinationen sind eine Beheizung nur von unten, eine Beheizung nur von der Seite oder eine Beheizung kombiniert von unten und von der Seite. Besonders bevorzugt erfolgt die Beheizung des Wachstumstiegels von der Seite mit einer optionalen Zusatzbeheizung von unten.

Nach einer weiteren vorteilhaften Ausgestaltung der Erfindung umfasst die Kristallzüchtungsanlage einen ersten und/oder einen zweiten Pyrometerzugang. Der erste und/oder zweite Pyrometerzugang ist vorzugsweise zur Bestimmung der Temperatur des Wachstumstiegels mittels eines optischen Pyrometers vorgesehen. Der erste Pyrometerzugang durchgreift die zweite thermische Isolation bis zum Tiegeldeckel vorzugsweise entlang der Rotationsachse des Wachstumstiegels. Eine Temperaturmessung des Wachstumstiegels durch den ersten Pyrometerzugang erfolgt vorzugsweise direkt am Tiegeldeckel. Ergänzend oder alternativ durchgreift der zweite Pyrometerzugang die erste thermische Isolation und/oder die Heizvorrichtung bis zum Tiegelboden vorzugsweise entlang der Rotationsachse des Wachstumstiegels. Eine Temperaturmessung des Wachstumstiegels durch den zweiten Pyrometerzugang erfolgt vorzugsweise direkt am Tiegelboden.

Die oben beschriebene bevorzugte Beheizung des Wachstumstiegels von der Seite mit einer optionalen Zusatzbeheizung von unten kann beispielsweise mit einem zweiten Pyrometerzugang kombiniert werden. Dazu wird ein schmaler Öffnungskanal in der ersten thermischen Isolation und in der zwischen dem Tiegelboden und der ersten thermischen Isolation angeordneten Heizvorrichtung als optischer Zugang vorgesehen. Somit kann vorteilhafterweise eine Temperaturmessung direkt am Tiegelboden erfolgen.

Nach einer weiteren vorteilhaften Ausgestaltung der Erfindung ist mittelbar oder unmittelbar oberhalb einer radial außenliegenden Ringfläche des Tiegeldeckels die erste thermische Isolation angeordnet. Dadurch ist es möglich, die Stärke des Wärmestroms aus dem Wachstumstiegel nach oben einzustellen.

Wie oben bereits beschrieben ist die zweite thermische Isolation mittelbar oder unmittelbar oberhalb des Tiegeldeckels angeordnet. Dabei bestehen verschiedene Möglichkeiten: Die zweite thermische Isolation kann vollflächig oberhalb des Tiegeldeckels angeordnet sein. Die zweite thermische Isolation kann oberhalb einer radial innenliegenden Kreisfläche des Tiegeldeckels angeordnet sein. Diese genannten Flächen können weiterhin von einem zentralen Pyrometerzugang durchgriffen werden, so dass die zweite thermische Isolation bei Vorhandensein eines zentralen Pyrometerzugangs oberhalb einer Ringfläche des Tiegeldeckels angeordnet sein kann. Bei der Ringfläche kann es sich je nach dem oben beschriebenen Fall um eine radial außenliegende oder eine radial innenliegende Ringfläche handeln. Aufgrund des geringen Durchmessers des Pyrometerzugangs können die genannten Ringflächen in Näherung auch als Kreisflächen bezeichnet werden.

In allen genannten Fällen ist eine mittelbare oder eine unmittelbare Anordnung der zweiten thermischen Isolation oberhalb des Tiegeldeckels möglich. In Bezug auf eine mittelbare Anordnung ist insbesondere der bereits oben beschriebene Hohlraum relevant. Der Hohlraum kann beispielsweise zwischen dem Tiegeldeckel einerseits und der radial außenliegenden ersten thermischen Isolation sowie der radial innenliegenden zweiten thermischen Isolation andererseits angeordnet sein.

Im Fall eines zylindrischen Wachstumstiegels und einer zylindrischen zweiten thermischen Isolation beträgt der Durchmesser der zweiten thermischen Isolation vorzugsweise zwischen 10 und 120% des Durchmessers des Wachstumstiegels. Besonders bevorzugt beträgt der Durchmesser der zweiten thermischen Isolation zwischen 80% des Durchmessers des Nutzbereichs des Einkristalls, das heißt des Durchmessers des als Produkt anvisierten Einkristalls, und 100% des Durchmessers des Wachstumstiegels. Bei quaderförmigem Wachstumstiegel und quaderförmiger zweiter thermischer Isolation werden entsprechende Größenverhältnisse bevorzugt.

Nach einer weiteren vorteilhaften Ausgestaltung der Erfindung ist der Tiegelboden, die Tiegelseitenwand und/oder der Tiegeldeckel des Wachstumstiegels aus Graphit und/oder TaC und/oder beschichtetem Graphit, insbesondere aus pyrolytisch mit Kohlenstoff beschichtetem Graphit und/oder aus mit Ta und/oder TaC beschichtetem Graphit, gebildet. Für eine pyrolytische Beschichtung mit Kohlenstoff kann auch die Kurzschreibweise PyC verwendet werden.

Vorzugsweise ist der Wachstumstiegel dazu geeignet auf Temperaturen im Bereich von 1000°C bis 2500°C, insbesondere Temperaturen im Bereich von 1500°C bis 2500°C aufgeheizt zu werden.

Nach einer weiteren vorteilhaften Ausgestaltung der Erfindung ist das Quellenmaterial im Wachstumstiegel in Abhängigkeit von Temperaturgradienten verdampfbar, und/oder transportierbar und/oder abscheidbar. Genauer gesagt wird das Quellenmaterial vorzugsweise in gasförmigem Zustand transportiert und/oder abgeschieden, das heißt als ein gasförmiges Vorläufermaterial. Die Temperaturgradienten sind im Wachstumstiegel gezielt einstellbar und/oder steuerbar. Die Temperaturgradienten lassen sich in axiale und radiale Temperaturgradienten unterscheiden. Genauer gesagt, weisen die Temperaturgradienten eine axiale und/oder eine radiale Komponente auf. Das Einstellen bzw. die Steuerung der Temperaturgradienten geht vorzugsweise mit einem Einstellen und/oder einer Steuerung der Wärmeströme innerhalb der Kristallzüchtungsanlage und insbesondere innerhalb des Wachstumstiegels einher. In der vorliegenden Anmeldung wird hauptsächlich Bezug auf die Temperaturgradienten genommen. Dabei versteht es sich von selbst, dass es sich um Temperaturgradienten im dreidimensionalen Inneren der Kristallzüchtungsanlage und insbesondere des Wachstumstiegels handelt. Tatsächlich soll mit der vorliegenden Erfindung das dreidimensionale Temperaturfeld im Inneren der Kristallzüchtungsanlage und insbesondere des Wachstumstiegels gesteuert und/oder eingestellt werden. Die Erfindung kann in entsprechender Weise verstanden werden, dass die Isothermen, insbesondere der Verlauf der Isothermen, im dreidimensionalen Inneren des Wachstumstiegels gesteuert und/oder eingestellt werden.

Die senkrecht zu den Isothermen verlaufenden Temperaturgradienten haben in der Kristallzüchtung eine wichtige Bedeutung. Entlang der senkrecht zu den Isothermen verlaufenden Temperaturgradienten sind die Gasdruckunterschiede lokal am stärksten ausgeprägt. Daher erfolgt der Stofftransport bzw. der Materialstrom vorzugsweise im Wesentlichen entlang dieser Temperaturgradienten senkrecht zu den Isothermen. Weiterhin verlaufen die Wärmeströme vorzugsweise entlang der senkrecht zu den Isothermen verlaufenden Temperaturgradienten.

Vorteilhafterweise wird durch die vorliegende Erfindung ein gleichmäßiger Wärmestrom in axialer Richtung eingestellt.

Nach einer weiteren vorteilhaften Ausgestaltung der Erfindung ist die Kristallzüchtungsanlage zur gezielten Einstellung und/oder Steuerung von Temperaturgradienten im Wachstumstiegel ausgebildet. Die Temperaturgradienten, insbesondere die radialen Temperaturgradienten bzw. der radiale Anteil der Temperaturgradienten, sind durch die Ausgestaltung der ersten und/oder zweiten thermischen Isolation derart einstellbar, dass die Isothermen einen konvexen Verlauf aufweisen. Die Isothermen weisen den konvexen Verlauf vorzugsweise innerhalb des Wachstumstiegels, besonders bevorzugt in einer Umgebung des wachsenden Einkristalls, insbesondere an der Wachstumsfront des wachsenden Einkristalls auf. Der konvexe Verlauf der Isothermen ergibt sich dabei vom Quellenmaterial aus gesehen. Die Isothermen bauchen also nach unten aus. Der konvexe Verlauf der Isothermen wird vorzugsweise dadurch erreicht, dass die radiale Komponente der Temperaturgradienten auf höchstens etwa 0,1 K/cm und die axiale Komponente der Temperaturgradienten auf zwischen 0,1 und mehr als 20 K/cm, vorzugsweise auf 0,2 bis 5 K/cm, besonders bevorzugt auf 0,3 bis 2 K/cm, eingestellt wird.

Nach einer weiteren vorteilhaften Ausgestaltung der Erfindung sind die Temperaturgradienten im Wachstumstiegel durch die Heizvorrichtung einstellbar. Wie oben erläutert kann die Heizvorrichtung durch unterschiedliche Heizeinheiten, insbesondere induktive Heizeinheiten und/oder Widerstandsheizeinheiten, ausgestaltet sein. Die Temperaturgradienten sind vorzugsweise durch die geometrische Anordnung von Heizeinheiten und/oder durch die Ausbildung verschiedener Heizzonen einstellbar. Weiterhin können die Temperaturgradienten durch ein Variieren der Heizleistung bei einer oder mehreren Heizeinheiten und/oder bei unterschiedlichen Heizzonen einstellbar.

Nach einer weiteren vorteilhaften Ausgestaltung der Erfindung besteht die erste thermische Isolation aus einem ersten Isolationsmaterial, insbesondere einem ersten Hochtemperaturisolationsmaterial. Die erste thermische Isolation besteht dabei vorzugsweise aus einem Feststoff, besonders bevorzugt aus Graphitfilz und/oder Graphitschaum. Zusätzlich oder alternativ besteht die zweite thermische Isolation aus einem zweiten Isolationsmaterial, insbesondere einem zweiten Hochtemperaturisolationsmaterial. Die zweite thermische Isolation besteht dabei vorzugsweise aus einem Feststoff, besonders bevorzugt aus Graphitschaum und/oder porösen Graphit.

Darunter wird vorzugsweise verstanden, dass die erste thermische Isolation vollständig mit dem ersten Isolationsmaterial ausgefüllt ist und/oder die zweite thermische Isolation vollständig mit dem zweiten Isolationsmaterial ausgefüllt ist.

Alternativ dazu kann die erste thermische Isolation das erste Isolationsmaterial, insbesondere das erste Hochtemperaturisolationsmaterial, vorzugsweise den Feststoff, besonders bevorzugt Graphitfilz und/oder Graphitschaum, aufweisen. Die zweite thermische Isolation kann das zweite Isolationsmaterial, insbesondere das zweite Hochtemperaturisolationsmaterial, vorzugsweise den Feststoff, besonders bevorzugt Graphitschaum und/oder porösen Graphit, aufweisen.

Das erste Isolationsmaterial und das zweite Isolationsmaterial unterscheiden sich vorzugsweise. Insbesondere unterscheidet sich das erste Isolationsmaterial vorzugsweise in seiner Wärmeleitfähigkeit vom zweiten Isolationsmaterial. Das erste Isolationsmaterial weist vorzugsweise die erste Wärmeleitfähigkeit auf. Das zweite Isolationsmaterial weist vorzugsweise die zweite Wärmeleitfähigkeit auf. Erfindungsgemäß ist die zweite Wärmeleitfähigkeit größer als die erste Wärmeleitfähigkeit. Der Unterschied zwischen dem ersten und dem zweiten Isolationsmaterial kann dabei in der Wahl unterschiedlicher Materialien oder in der Bereitstellung unterschiedlicher Beschaffenheiten gleichartiger Materialen bestehen, beispielsweise unterschiedlich dichter Graphitschäume.

Nach einer weiteren vorteilhaften Ausgestaltung der Erfindung ist die zweite thermische Isolation aus einer Abfolge mehrerer jeweils zueinander beabstandeter Platten gebildet. Die Platten sind vorzugsweise kreisscheibenförmig.

Jede einzelne Platte reflektiert dabei vorzugsweise einen möglichst hohen Anteil der auf sie auftreffenden Wärmestrahlung und transmittiert vorzugsweise einen möglichst niedrigen Anteil der auf sie auftreffenden Wärmestrahlung. Die Platten wirken also vorzugsweise als Strahlungsschilde.

Erfindungsgemäß gilt auch bei dieser vorteilhaften Ausgestaltung, dass die zweite Wärmeleitfähigkeit größer ist als die erste Wärmeleitfähigkeit. Bei der Abfolge mehrerer Platten wird unter der zweiten Wärmeleitfähigkeit eine effektive Wärmeleitfähigkeit verstanden. Die effektive Wärmeleitfähigkeit kann aus dem absoluten Wärmeleitwert der gesamten Abfolge der mehreren Platten durch Herausrechnen einer Fläche und einer Dicke der gesamten Abfolge der mehreren Platten bestimmt werden. Unter dem Wärmeleitwert wird dabei der Kehrwert des Wärmewiderstands verstanden.

Nach einer weiteren vorteilhaften Ausgestaltung der Erfindung ist die zweite thermische Isolation aus zwei bis zehn, vorzugsweise aus drei bis fünf, Platten gebildet.

Nach einer weiteren vorteilhaften Ausgestaltung der Erfindung sind die Platten aus einem hochtemperaturstabilen Material gebildet. Das hochtemperaturstabile Material ist vorzugsweise Graphit, beschichtetes Graphit, Metallkarbid und/oder hochtemperaturschmelzendes Metall.

Bei dem beschichteten Graphit kann es sich z.B. um mit pyrolytischem Kohlenstoff, Ta, TaC und/oder SiC beschichtetes Graphit handeln. Das Metallkarbid kann z.B. Tantalkarbid sein. Das hochtemperaturschmelzende Metall kann z.B. Ta, W und/oder Zr sein.

Nach einer weiteren vorteilhaften Ausgestaltung der Erfindung weisen die Platten jeweils eine Dicke zwischen 0,1 und 10 mm, vorzugsweise 0,5 bis 3 mm, auf.

Nach einer weiteren vorteilhaften Ausgestaltung der Erfindung weisen aufeinanderfolgende Platten jeweils einen Abstand im Bereich von 1 bis 50 mm, vorzugsweise 5 bis 20 mm, auf.

Der Abstand wird vorzugsweise durch einen oder mehrere Abstandhalter eingestellt. Der oder die Abstandhalter weisen beispielweise eine Dicke von 0,5 mm bis 5 mm, vorzugsweise 0,5 bis 3 mm auf. Der oder die Abstandhalter sind vorzugsweise aus einem hochtemperaturstabilen Material gebildet, bevorzugt aus dem gleichen Material wie die Platten. Alternativ können der oder die Abstandhalter aus einem anderen, idealerweise thermisch isolierenden Material gebildet sein, beispielsweise Graphitschäume oder Filze.

Mehrere Abstandhalter können beispielweise als dünne Stangen ausgestaltet sein. Die Abstandhalter können alternativ dazu als Ringe ausgestaltet sein. Die Ringe können insbesondere aus einem thermisch isolierenden Material, beispielsweise Graphitschäume oder Filze bestehen. Die Abstandhalter sind vorzugsweise in einem radial außenliegenden Bereich der Platten angeordnet.

Alternativ oder ergänzend kann ein ringförmiger Aufnahmekörper mit darin vorgesehenen Aufnahmenuten vorgesehen sein. Die Platten greifen dabei vorzugsweise mit ihrem radial außenliegenden Bereich in die Aufnahmenuten. Der Aufnahmekörper ist vorzugsweise aus thermisch isolierendem Material hergestellt, beispielsweise aus Graphitschaum oder Filz

Nach einer weiteren vorteilhaften Ausgestaltung der Erfindung weisen die Platten an ihren Oberflächen einen definiert eingestellten Emissionsgrad auf, vorzugsweise einen Emissionsgrad von höchstens 0,4 oder einen Emissionsgrad von mindestens 0,6. Besonders bevorzugt wird ein Emissionsgrad von höchstens 0,3 oder ein Emissionsgrad von mindestens 0,7.

Neben der Anzahl der Platten kann der Emissionsgrad der Oberflächen der Platten die Stärke der thermischen Isolation beeinflussen. Beim Vorsehen eines niedrigen beidseitigen Emissionsgrads kann vorzugsweise eine geringere Anzahl von Platten vorgesehen werden als beim Vorsehen eines höheren beidseitigen Emissionsgrads.

Beispielsweise bieten in einem Temperaturbereich von 1500°C bis 2500°C drei bis fünf Platten mit einem beidseitigen Emissionsgrad von 0,3 die gleiche Hochtemperatur-Isolation wie fünf bis acht Platten mit einem beidseitigen Emissionsgrad von 0,7. Die Platten mit dem beidseitigen Emissionsgrad von 0,3 sind z.B. aus Graphit mit einer TaC-Beschichtung oder aus TaC hergestellt. Die Platten mit einem beidseitigen Emissionsgrad von 0,7 weisen z.B. eine glänzende Graphitoberfläche auf. Die von der genannten Anzahl an Platten erreichte Hochtemperatur-Isolation entspricht vorzugsweise der Hochtemperatur-Isolation eines Graphitschaums oder Graphitfilzes im gleichen Temperaturbereich.

Nach einer weiteren vorteilhaften Ausgestaltung der Erfindung unterscheiden sich die Emissionsgrade aufeinanderfolgender Platten. Zusätzlich oder alternativ unterscheiden sich die Emissionsgrade an einer Unterseite und an einer Oberseite einer oder mehrerer Platten.

Dadurch ist ein genaueres Einstellen der effektiven Wärmeleitfähigkeit und damit der erreichten Hochtemperatur-Isolation möglich.

Nach einer weiteren vorteilhaften Ausgestaltung der Erfindung weisen die Platten jeweils mehrere längliche Einschnitte auf. Die Einschnitte verlaufen vorzugsweise jeweils in radialer Richtung ausgehend von einem äußeren Umfang der Platten. Die Einschnitte dringen dabei vorzugsweise nicht in einen radial innenliegenden Bereich der Platten ein. Insbesondere treffen sich die Einschnitte vorzugsweise nicht. Vorzugsweise weisen benachbarte Einschnitte einen Winkelabstand zwischen 5° und 90°, bevorzugt zwischen 10° und 45°, besonders bevorzugt zwischen 15° und 30°, zueinander auf. Benachbarte Einschnitte weisen vorzugsweise jeweils den gleichen Winkelabstand zueinander auf.

Durch Vorsehen solcher Einschnitte kann vorteilhafterweise eine induktive Einkopplung von Induktionsleistung in die Platten vermieden oder zumindest stark reduziert werden.

Vorzugsweise sind benachbarte Platten zueinander derart verdreht, dass die jeweiligen Einschnitte zueinander versetzt sind. Die benachbarten Platten sind dabei vorzugsweise um die Hälfte des Winkelabstands benachbarter Einschnitte verdreht. Dadurch kann vorteilhafterweise eine eventuell störende vertikale Durchstrahlung der Wärme durch die Einschnitte hindurch unterbunden werden.

Nach Maßgabe der Erfindung wird weiterhin ein Verfahren zur Herstellung und/oder Vergrößerung eines Einkristalls durch Aufheizen, Verdampfen und Abscheiden eines Quellenmaterials im Wachstumstiegel einer erfindungsgemäßen Kristallzüchtungsanlage beansprucht. Die Herstellung und/oder Vergrößerung des Einkristalls erfolgt dabei vorzugsweise nach dem PVT-Verfahren.

Das Verfahren umfasst die folgenden Schritte:
- Aufheizen des Quellenmaterials und des Einkristalls, so dass sich ein Temperaturgradient zwischen dem Quellenmaterial und dem Einkristall ausbildet. Hierbei bildet sich vorzugsweise ein in axialer Richtung verlaufender oder ein im Wesentlichen in axialer Richtung verlaufender Temperaturgradient aus. Das Quellenmaterial wird vorzugsweise auf Temperaturen von 1750°C bis 2500°C, besonders bevorzugt von 1900°C bis 2300°C, aufgeheizt.
- Verdampfen von heißem Quellenmaterial zur Bildung von gasförmigen Vorläufermaterial in der Gasphase. Das Quellenmaterial wird hierbei vorzugsweise sublimiert. Das gasförmige Vorläufermaterial wird sodann vorzugsweise in der Gasphase transportiert. Im Beispiel von SiC als Quellenmaterial umfasst das gasförmige Vorläufermaterial im Wesentlichen vorzugsweise gasförmiges SiC₂, gasförmiges Si und gasförmiges Si₂C.
- Abscheiden des gasförmigen Vorläufermaterials aus der Gasphase am Einkristall. Der Einkristall wird also vorzugsweise durch Anlagern des gasförmigen Vorläufermaterials vergrößert. Der ursprünglich vorgesehene Kristallkeim wird dadurch vorzugsweise immer weiter überwachsen. Der Einkristall wächst dabei insbesondere in axialer Richtung. Bei der Verwendung von SiC als Quellenmaterial wird SiC am Einkristall angelagert. Bei der Verwendung von AIN als Quellenmaterial wird AIN am Einkristall angelagert.

Der Wachstumstiegel ist vorzugsweise zylindrisch oder im Wesentlichen zylindrisch. Alternativ kann der Wachstumstiegel quaderförmig oder im Wesentlichen quaderförmig sein.

Das Quellenmaterial wird in Abhängigkeit von Temperaturgradienten verdampft, und/oder transportiert und/oder abgeschieden. Genauer gesagt wird das Quellenmaterial vorzugsweise in gasförmigem Zustand transportiert und/oder abgeschieden, das heißt als ein gasförmiges Vorläufermaterial. Die Temperaturgradienten werden gezielt eingestellt und/oder gesteuert.

Der Wachstumstiegel weist einen Tiegelboden, eine Tiegelseitenwand und einen Tiegeldeckel auf. Der Tiegelboden kann als untere Tiegelwand, die Tiegelseitenwand als seitliche Tiegelwand und der Tiegeldeckel als obere Tiegelwand bezeichnet werden. Die Tiegelseitenwand ist mittelbar oder unmittelbar von einer ersten thermischen Isolation mit einer ersten Wärmeleitfähigkeit umgeben. Die erste thermische Isolation besteht vorzugsweise aus einem ersten Isolationsmaterial, insbesondere einem ersten Hochtemperaturisolationsmaterial. Dabei handelt es sich um einen Feststoff, z.B. Graphitfilz und/oder Graphitschaum. Oberhalb des Tiegeldeckels ist mittelbar oder unmittelbar eine zweite thermische Isolation mit einer zweiten Wärmeleitfähigkeit angeordnet. Die zweite thermische Isolation besteht vorzugsweise aus einem zweiten Isolationsmaterial, insbesondere einem zweiten Hochtemperaturisolationsmaterial. Dabei handelt es sich um einen Feststoff, z.B. Graphitschaum und/oder porösen Graphit. Die zweite Wärmeleitfähigkeit ist größer als die erste Wärmeleitfähigkeit.

Die Temperaturgradienten, insbesondere die radialen Temperaturgradienten bzw. der radiale Anteil der Temperaturgradienten, werden durch die Ausgestaltung der ersten und/oder zweiten thermischen Isolation derart eingestellt, dass die Isothermen einen konvexen Verlauf aufweisen. Die Isothermen weisen den konvexen Verlauf vorzugsweise innerhalb des Wachstumstiegels, besonders bevorzugt in einer Umgebung des wachsenden Einkristalls, insbesondere an der Wachstumsfront des wachsenden Einkristalls auf. Der konvexe Verlauf der Isothermen ergibt sich dabei vom Quellenmaterial aus gesehen. Die Isothermen bauchen also nach unten aus. Der konvexe

Verlauf der Isothermen wird vorzugsweise dadurch erreicht, dass die radiale Komponente der Temperaturgradienten auf höchstens etwa 0,1 K/cm und die axiale Komponente der Temperaturgradienten auf zwischen 0,1 und mehr als 20 K/cm, vorzugsweise auf 0,2 bis 5 K/cm, besonders bevorzugt auf 0,3 bis 2 K/cm, eingestellt wird.

Die folgende Tabelle zeigt bevorzugte Werte der Wärmeleitfähigkeit verschiedener in der Kristallzüchtungsanlage einsetzbarer Materialien.

| | **Bevorzugter Wert k @RT [W/(m*K)]** | **Parameterbereich k @RT [W/(m*K)]** | **bevorzugter Bereich k @RT [W/(m*K)]** |
|---|---|---|---|
| **dichter Graphit** | 75 | 40 bis 100 | |
| **erste thermische Isolation** | 0,5 | 0,05 bis 5 | 0,1 bis 2 |
| **zweite thermische Isolation** | 10 | 2 bis 50 | 5 bis 20 |
| **SiC-Einkristall** | 25 | | |
| **SiC-Pulver mit 50% Dichte** | 1 | | |

Es versteht sich von selbst, dass die in der vorliegenden Anmeldung genannten Materialdaten temperaturabhängige Eigenschaften aufweisen. Die beispielsweise bei Raumtemperatur angegebenen Werte der Wärmeleitfähigkeit und/oder des Emissionsgrads (ε) können sich unter Einfluss der Prozesstemperatur verändern. Der Trend in den Unterschieden bleibt jedoch auch bei hohen Temperaturen erhalten.

Die Erfindung wird nun anhand von Ausführungsbeispielen näher erläutert. Es zeigen
- Fig. 1A: eine schematische Darstellung eines Wachstumstiegels nach dem Stand der Technik,
- Fig. 1B: eine schematische Darstellung einer Kristallzüchtungsanlage mit Wachstumstiegels nach dem Stand der Technik,
- Fig. 2: eine schematische Darstellung einer ersten erfindungsgemäßen Kristallzüchtungsanlage mit Wachstumstiegel,
- Fig. 3A: eine schematische Darstellung einer zweiten erfindungsgemäßen Kristallzüchtungsanlage mit Wachstumstiegel,
- Fig. 3B: eine schematische Darstellung einer dritten erfindungsgemäßen Kristallzüchtungsanlage mit Wachstumstiegel,
- Fig. 3C: eine schematische Darstellung einer vierten erfindungsgemäßen Kristallzüchtungsanlage mit Wachstumstiegel,
- Fig. 3D: eine schematische Darstellung einer fünften erfindungsgemäßen Kristallzüchtungsanlage mit Wachstumstiegel,
- Fig. 3E: eine schematische Darstellung einer sechsten erfindungsgemäßen Kristallzüchtungsanlage mit Wachstumstiegel,
- Fig. 3F: eine schematische Darstellung einer siebten erfindungsgemäßen Kristallzüchtungsanlage mit Wachstumstiegel,
- Fig. 4: eine schematische Darstellung einer achten erfindungsgemäßen Kristallzüchtungsanlage mit Wachstumstiegel,
- Fig. 5A: eine schematische Darstellung einer neunten erfindungsgemäßen Kristallzüchtungsanlage mit Wachstumstiegel,
- Fig. 5B: eine schematische Darstellung einer zehnten erfindungsgemäßen Kristallzüchtungsanlage mit Wachstumstiegel,
- Fig. 6: eine schematische Darstellung einer elften erfindungsgemäßen Kristallzüchtungsanlage mit Wachstumstiegel,
- Fig. 7A - 7C: vergrößerte Detailansichten mit verschiedenen Ausgestaltungen der elften erfindungsgemäßen Kristallzüchtungsanlage,
- Fig. 8: eine schematische dreidimensionale Ansicht einer zweiten thermischen Isolation als Abfolge aus fünf Platten,
- Fig. 9: einen mittigen zweidimensionalen Schnitt durch die in Fig. 8 gezeigte Abfolge aus fünf Platten in einer ersten Ausgestaltung,
- Fig. 10A: einen mittigen zweidimensionalen Schnitt durch die in Fig. 8 gezeigte Abfolge aus fünf Platten in einer zweiten Ausgestaltung,
- Fig. 10B: einen mittigen zweidimensionalen Schnitt durch die in Fig. 8 gezeigte Abfolge aus fünf Platten in einer dritten Ausgestaltung, und
- Fig. 11: schematische Darstellungen von mit länglichen Einschnitten versehenen Platten.

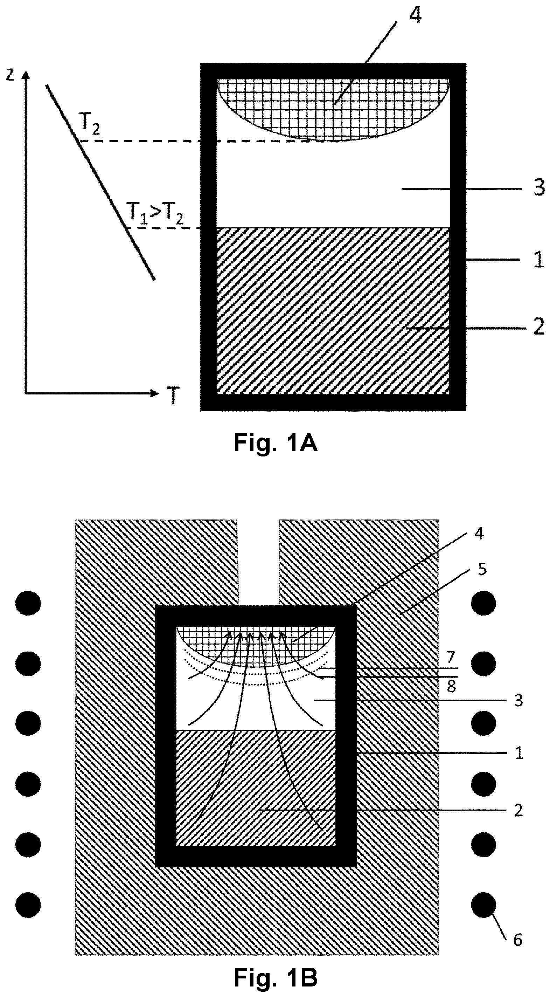

Fig. 1A zeigt eine schematische Darstellung eines Wachstumstiegels nach dem Stand der Technik. Der zylindrische Wachstumstiegel weist eine Tiegelwand 1 auf. Die Tiegelwand 1 gliedert sich in einen Tiegelboden, eine Tiegelseitenwand und einen Tiegeldeckel. Im Inneren des Wachstumstiegels sind ein Quellenmaterial 2, ein Gasraum 3 und ein Einkristall 4 aufgenommen. Das Quellenmaterial 2 und der Einkristall 4 sind an den beiden axial gegenüberliegenden Enden des Inneren des Wachstumstiegels angeordnet und dabei durch den Gasraum 3 voneinander getrennt. Das Quellenmaterial 2 hat eine im Wesentlichen zylindrische Form. Der Einkristall 4 hat die Form eines einseitig konvex abgerundeten Zylinders. Das Quellenmaterial 2 ist beispielsweise ein Pulver aus Siliziumkarbid (in Formelschreibweise SiC). Als Einkristall 4 wird entsprechend ein Einkristall aus SiC hergestellt.

Der Wachstumstiegel wird zur Vergrößerung des Einkristalls 4 so aufgeheizt, dass Quellenmaterial 2 durch Sublimation in die Gasphase übergeht, als gasförmiges Vorläufermaterial durch den Gasraum transportiert wird und am Einkristall 4 auskristallisiert.

Dem Wachstumstiegel ist schematisch der Verlauf der Temperatur T in z-Richtung, das heißt in Axialrichtung des Wachstumstiegels gegenübergestellt. Die Temperatur an der an den Gasraum 3 angrenzenden Grenzfläche des Quellenmaterials 2 beträgt T₁. Die Grenzfläche des Quellenmaterials 2 ist vorzugsweise eben oder im Wesentlichen eben. Vorzugsweise ist die Temperatur entlang der Grenzfläche des Quellenmaterials 2 konstant. Die Grenzfläche des Quellenmaterials 2 liegt also vorzugsweise auf einer Isothermen mit der Temperatur T₁. Die Temperatur T₁ ist ausreichend hoch eingestellt, dass es zu einer Sublimation von Quellenmaterial 2 kommt. Die Temperatur an der an den Gasraum 3 angrenzenden Grenzfläche des Einkristalls 4 beträgt T₂. Diese Grenzfläche des Einkristalls 4 hat eine konvexe Form und kann auch als Wachstumsgrenzfläche bezeichnet werden. Vorzugsweise ist die Temperatur entlang der konvexen Wachstumsgrenzfläche konstant. Die Wachstumsgrenzfläche ist also vorzugsweise entlang einer Isotherme mit der Temperatur T₂ ausgebildet. Die Temperatur T₂ ist kleiner als die Temperatur T₁. Zwischen dem Quellenmaterial 2 und dem Einkristall 4 ist also ein axialer Temperaturgradient ausgebildet. Die Temperatur T₂ ist so eingestellt, dass es zu einer Übersättigung des gasförmigen Vorläufermaterials, insbesondere zu einer Übersättigung der Wachstumsspezies, und dadurch zu einer Kristallisation am Einkristall 4 kommt. Das Quellenmaterial 2 wird durch die Sublimation fortwährend abgetragen. Der Einkristall 4 wird durch die Kristallisation fortwährend vergrößert. Vorzugsweise bildet sich die Wachstumsgrenzfläche dabei beständig entlang einer Isotherme.

Fig. 1B zeigt eine schematische Darstellung einer Kristallzüchtungsanlage mit Wachstumstiegels nach dem Stand der Technik. Die Kristallzüchtungsanlage weist eine thermische Isolation 5 und eine induktive Heizeinheit 6 auf. Die thermische Isolation 5 umgibt den Wachstumstiegel bis auf eine im Bereich des Tiegeldeckels vorgesehene Öffnung. Diese Öffnung hat die Funktion eines Abstrahlkanals über den Wärme nach oben hin aus dem Wachstumstiegel abtransportiert wird. Die Wärme wird dabei bevorzugt über Wärmestrahlung nach oben hin abtransportiert. Wärmestrahlung ist der Wärmetransportmechanismus, der bei Temperaturen ab 500 °C eine Rolle spielt und bei Temperaturen > 1000 °C den Wärmetransport in (teil-)transparenten Medien dominiert. Durch den Abtransport der Wärme durch den Abstrahlkanal wird ein axialer Temperaturgradient im Wachstumstiegel vorgesehen.

Der Abstrahlkanal bewirkt eine Bündelung des Wärmestroms 8. Dadurch wird eine erhebliche radiale Komponente des Wärmestroms 8 innerhalb des Wachstumstiegels erzeugt. Entsprechend weisen die Temperaturgradienten im Wachstumstiegel eine starke radiale Komponente auf. Die Isothermen 7 weisen daher vom Quellenmaterial 2 aus betrachtet eine ausgeprägte konvexe Form auf. Da sich die Wachstumsgrenzfläche des wachsenden Einkristalls 4 wie oben beschrieben entlang einer Isotherme 7 ausbildet, entsteht somit ein stark konvexer Einkristall.

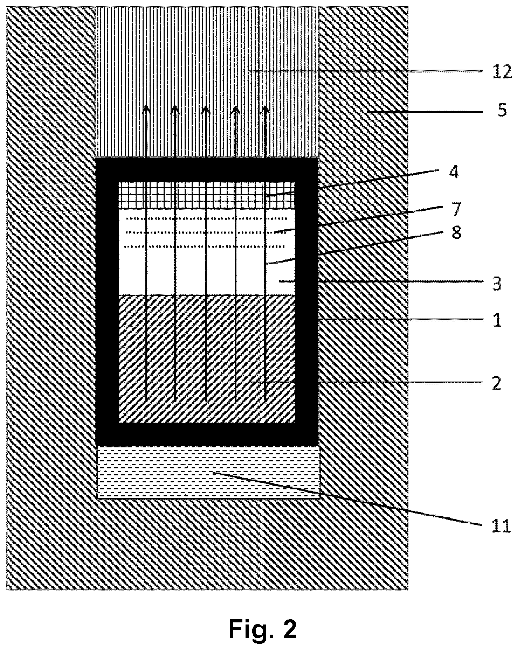

Die Figuren 2 bis 6 zeigen jeweils schematische Darstellungen einer ersten bis elften erfindungsgemäßen Kristallzüchtungsanlage umfassend einen Wachstumstiegel. Die Kristallzüchtungsanlage und der Wachstumstiegel weisen in allen Ausführungsformen der Erfindung jeweils alle beschriebenen Elemente und Eigenschaften der Kristallzüchtungsanlage und des Wachstumstiegels aus den Fig. 1 auf. Zusätzlich weist die Kristallzüchtungsanlage jeweils sowohl eine erste thermische Isolation 5 mit einer ersten Wärmeleitfähigkeit als auch eine zweite thermische Isolation 12 mit einer zweiten Wärmeleitfähigkeit auf. Die erste Wärmeleitfähigkeit ist dabei jeweils kleiner als die zweite Wärmeleitfähigkeit. Die erste thermische Isolation 5 besteht aus einem ersten Hochtemperaturisolationsmaterial, beispielsweise aus einem Graphitfilz und/oder Graphitschaum. Bei der ersten thermischen Isolation 5 handelt es sich um eine thermisch hohe Isolation. Die zweite thermische Isolation 12 besteht aus einem zweiten Hochtemperaturisolationsmaterial, beispielsweise aus einem Graphitschaum und/oder porösen Graphit. Bei der zweiten thermischen Isolation 12 handelt es sich um eine thermisch mittel-hohe Isolation. Die erste Wärmeleitfähigkeit ist entsprechend klein und beträgt beispielsweise 0,5 W/(m*K). Die zweite Wärmeleitfähigkeit ist mittelgroß und liegt beispielsweise bei 10 W/(m*K).

**In** den Ausführungsbeispielen ist die Tiegelseitenwand mittelbar oder unmittelbar von der ersten thermischen Isolation vollständig umgeben. Die erste thermische Isolation ist dabei jeweils als Hohlzylinder bzw. im Wesentlichen als Hohlzylinder ausgebildet. Die zweite thermische Isolation ist mittelbar oder unmittelbar oberhalb des Tiegeldeckels angeordnet. Die zweite thermische Isolation ist dabei jeweils als Vollzylinder ausgebildet und ist radial jeweils vollständig von der ersten thermischen Isolation umgeben.

Fig. 2 zeigt eine schematische Darstellung einer ersten erfindungsgemäßen Kristallzüchtungsanlage mit Wachstumstiegel. Anhand der Fig. 2 wird das Grundprinzip der Erfindung erläutert. Die becherförmige erste thermische Isolation 5 umschließt eine vollflächig unter dem Tiegelboden des Wachstumstiegels angeordnete untere Wärmequelle 11, den Wachstumstiegel sowie die vollflächig oberhalb des Tiegeldeckels angeordnete zweite thermische Isolation 12.

Durch die Anordnung der unteren Wärmequelle 11 vollflächig unmittelbar unter dem Tiegelboden des Wachstumstiegels, durch Vorsehen einer vernachlässigbar geringen Wärmeleitfähigkeit der ersten thermischen Isolation 5 und durch die Anordnung der zweiten thermischen Isolation 12 mit mittelhoher thermischer Isolation vollflächig unmittelbar oberhalb des Tiegeldeckels wird der Wärmestrom 8 in axialer Richtung durch den Wachstumstiegel und durch den wachsenden Einkristall 4 geführt. Im Idealfall unter Vernachlässigung der geringen Wärmeleitfähigkeit der ersten thermischen Isolation 5 wird ein ausschließlich axialer Wärmestrom 8 von unten nach oben realisiert. Die Isothermen 7 sind in diesem Idealfall waagerecht. Da sich die Wachstumsgrenzfläche des wachsenden Einkristalls 4 wie oben beschrieben entlang einer Isotherme 7 ausbildet, entsteht somit ein ebener Einkristall.

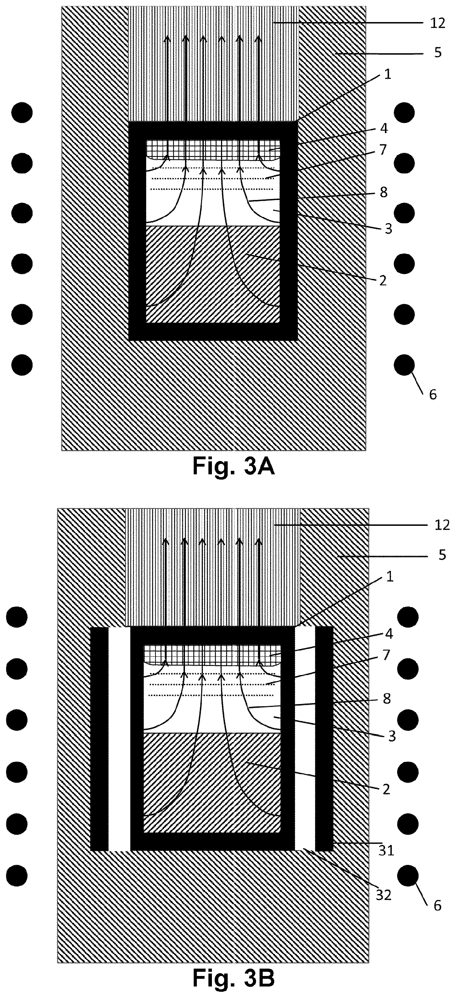

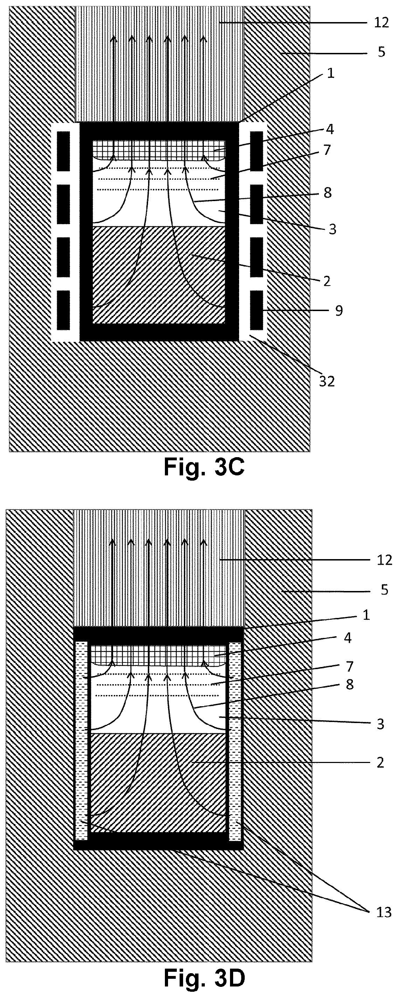

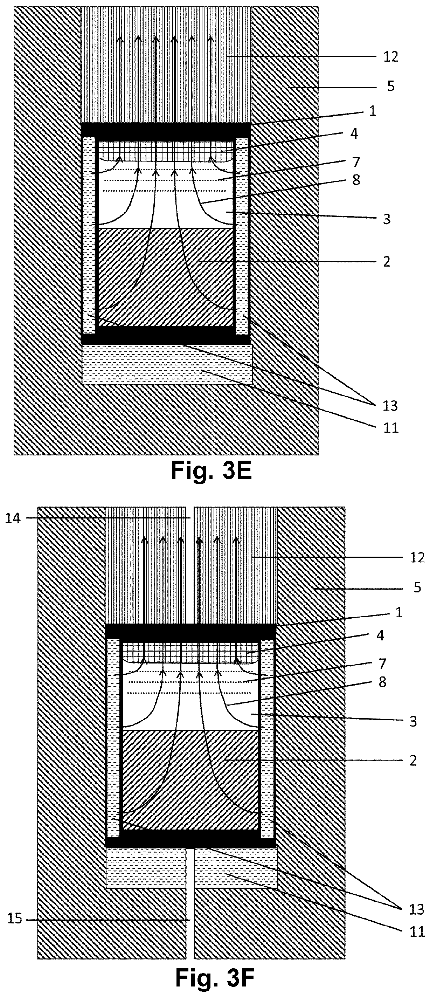

Beim Vorsehen einer ersten thermischen Isolation 5 mit einer realen, (möglichst) hohen thermischen Isolation erhält der Abtransport der Wärme aus dem Wachstumstiegel eine kleine radiale Komponente nach seitlich außen. Dadurch entstehen vom Quellenmaterial 2 aus betrachtet leicht konkave Isothermen 7 an der Kristallwachstumsfront. Die sich entlang einer Isotherme 7 ausbildende Wachstumsgrenzfläche des wachsenden Einkristalls 4 nimmt somit auch eine leicht konkave Form an. Dies hat jedoch den massiven Einbau von Kristallbaufehlern zur Folge. Durch eine zumindest teilweise Beheizung der Tiegelseitenwand kann der oben genannte seitlich nach außen erfolgende Abtransport der Wärme aus dem Wachstumstiegel überkompensiert werden. Dadurch kann die leicht konkave Ausbildung der Wachstumsgrenzfläche und der für das Kristallwachstum negativen Effekt des Einbaus von Kristallbaufehlern verhindert werden. Daher ist bei der zweiten bis elften erfindungsgemäßen Kristallzüchtungsanlage in den Figuren 3 bis 6 jeweils eine seitliche Wärmequelle 6, 9, 13 vorgesehen. Vorteilhafterweise wird dadurch im Bereich des wachsenden Einkristalls 4 ein definierter axialer Temperaturgradient bei möglichst kleinem radialen Temperaturgradienten bereitgestellt.

Fig. 3A zeigt eine schematische Darstellung einer zweiten erfindungsgemäßen Kristallzüchtungsanlage. Die becherförmige erste thermische Isolation 5 umschließt den Wachstumstiegel sowie die vollflächig oberhalb des Tiegeldeckels angeordnete zweite thermische Isolation 12. Die zweite erfindungsgemäße Kristallzüchtungsanlage weist eine seitliche Wärmequelle in Form einer induktiven Heizeinheit 6 auf. Die mittels der induktiven Heizeinheit 6 erzeugte Induktionsleistung wird in der Tiegelseitenwand aufgenommen. Dazu ist der Wachstumstiegel aus einem leitfähigen Material, z.B. Graphit, gebildet. Die induktive Heizeinheit 6 bewirkt also eine Erwärmung der Tiegelseitenwand mittels Induktion. Durch die Erwärmung der Tiegelseitenwand wird ein Wärmestrom 8 mit einer radialen Komponente von der Tiegelseitenwand ins Tiegelinnere erzeugt. Durch das Vorsehen der zweiten thermischen Isolation 12 wird der Wärmestrom 8 im Tiegelinneren in axialer Richtung durch den wachsenden Einkristall 4 geführt. Die Isothermen 7 an der Kristallwachstumsfront sind dadurch vom Quellenmaterial 2 aus betrachtet leicht konvex. Die sich entlang einer Isotherme 7 ausbildende Wachstumsgrenzfläche des wachsenden Einkristalls 4 nimmt somit auch eine leicht konvexe Form an. Dadurch herrschen günstige Voraussetzungen für das Wachstum des Einkristalls 4.

Fig. 3B zeigt eine schematische Darstellung einer dritten erfindungsgemäßen Kristallzüchtungsanlage. Zusätzlich zur zweiten erfindungsgemäßen Kristallzüchtungsanlage ist zwischen der Tiegelseitenwand und der ersten thermischen Isolation 5 ein Suszeptor 31 mit einem materialfreien Bereich 32 angeordnet. Der Suszeptor 31 dient zur primären Aufnahme der mittels der induktiven Heizeinheit 6 erzeugten Induktionsleistung. Der Suszeptor 31 ist beispielsweise aus Graphit gebildet. Der materialfreie Bereich 32 enthält beispielsweise ein Vakuum oder ein Gas. Durch Vorsehen des Suszeptors 31 wird die Aufnahme der Induktionsleistung verbessert.

Fig. 3C zeigt eine schematische Darstellung einer vierten erfindungsgemäßen Kristallzüchtungsanlage. Die vierte erfindungsgemäße Kristallzüchtungsanlage weist eine seitliche Wärmequelle in Form einer Widerstandsheizeinheit 9 auf. Die Widerstandsheizeinheit 9 weist einen materialfreien Bereich 32 auf und umgibt die Tiegelseitenwand. Im gezeigten Beispiel umgibt die Widerstandsheizeinheit 9 die Tiegelseitenwand vollständig. Die becherförmige erste thermische Isolation 5 umschließt den Wachstumstiegel zusammen mit der Widerstandsheizeinheit 9 sowie die vollflächig oberhalb des Tiegeldeckels angeordnete zweite thermische Isolation 12. Die Widerstandsheizeinheit 9 bewirkt eine Erwärmung der Tiegelseitenwand. Durch die Erwärmung der Tiegelseitenwand wird ein Wärmestrom 8 mit einer radialen Komponente von der Tiegelseitenwand ins Tiegelinnere erzeugt. Wie bereits oben erläutert wird der Wärmestrom 8 im Tiegelinneren durch das Vorsehen der zweiten thermischen Isolation 12 in axialer Richtung durch den wachsenden Einkristall 4 geführt. Die Isothermen 7 an der Kristallwachstumsfront sind dadurch vom Quellenmaterial 2 aus betrachtet leicht konvex. Die sich entlang einer Isotherme 7 ausbildende Wachstumsgrenzfläche des wachsenden Einkristalls 4 nimmt somit auch eine leicht konvexe Form an. Dadurch herrschen günstige Voraussetzungen für das Wachstum des Einkristalls 4.

Fig. 3D zeigt eine schematische Darstellung einer fünften erfindungsgemäßen Kristallzüchtungsanlage. Die fünfte erfindungsgemäße Kristallzüchtungsanlage weist eine beliebige seitliche Wärmequelle 13 auf. Die fünfte erfindungsgemäße Kristallzüchtungsanlage kann daher zur zweiten, dritten oder vierten erfindungsgemäßen Kristallzüchtungsanlage identisch sein. Die seitliche Wärmequelle 13 ist daher lediglich schematisch durch eine veränderte Darstellung der Tiegelseitenwand kenntlich gemacht. Insbesondere kann es sich bei der seitliche Wärmequelle 13 um eine Kombination der im Rahmen der zweiten erfindungsgemäßen Kristallzüchtungsanlage besprochenen induktiven Heizeinheit 6 und der im Rahmen der vierten erfindungsgemäßen Kristallzüchtungsanlage besprochenen Widerstandsheizeinheit 9 handeln. Weiterhin kann es sich bei der seitliche Wärmequelle 13 um eine Kombination der im Rahmen der dritten erfindungsgemäßen Kristallzüchtungsanlage besprochenen induktiven Heizeinheit 6 mit Suszeptor 31 und der im Rahmen der vierten erfindungsgemäßen Kristallzüchtungsanlage besprochenen Widerstandsheizeinheit 9 handeln. Es ergeben sich jeweils die oben entsprechend genannten Vorteile.

Fig. 3E zeigt eine schematische Darstellung einer sechsten erfindungsgemäßen Kristallzüchtungsanlage. Die sechste erfindungsgemäße Kristallzüchtungsanlage weist eine beliebige seitliche Wärmequelle 13 auf und entspricht in diesem Aspekt der zweiten bis fünften erfindungsgemäßen Kristallzüchtungsanlage. In Bezug auf die damit vorhandenen Merkmale und erreichten Vorteile wird daher auf die Erläuterungen zur zweiten bis fünften erfindungsgemäßen Kristallzüchtungsanlage verwiesen. Zusätzlich weist die sechste erfindungsgemäße Kristallzüchtungsanlage eine unter dem Tiegelboden des Wachstumstiegels angeordnete untere Wärmequelle 11 auf. Im gezeigten Beispiel ist die untere Wärmequelle 11 vollflächig unter dem Tiegelboden angeordnet. Die becherförmige erste thermische Isolation 5 umschließt somit die untere Wärmequelle 11, den optional von einer Widerstandsheizeinheit und/oder einem Suszeptor 31 umgebenen Wachstumstiegel sowie die vollflächig oberhalb des Tiegeldeckels angeordnete zweite thermische Isolation 12. Die untere Wärmequelle 11 kann insbesondere als Widerstandsheizung realisiert sein. Durch Vorsehen der unteren Wärmequelle 11 wird die axiale Komponente des Wärmestroms 8 durch den Wachstumstiegel und durch den wachsenden Einkristall 4 verstärkt. Die untere Wärmequelle 11 wirkt also zusammen mit der zweiten thermischen Isolation 12 in der Schaffung eines Wärmestroms 8 in axialer Richtung zusammen. Durch die zusätzliche seitliche Wärmequelle 13 und die damit bewirkte Erwärmung der Tiegelseitenwand wird eine leichte radiale Komponente des Wärmestroms 8 von der Tiegelseitenwand ins Tiegelinnere erzeugt. Die Isothermen 7 an der Kristallwachstumsfront sind dadurch vom Quellenmaterial 2 aus betrachtet leicht konvex. Die sich entlang einer Isotherme 7 ausbildende Wachstumsgrenzfläche des wachsenden Einkristalls 4 nimmt somit auch eine leicht konvexe Form an. Dadurch herrschen besonders günstige Voraussetzungen für das Wachstum des Einkristalls 4.

Fig. 3F zeigt eine schematische Darstellung einer siebten erfindungsgemäßen Kristallzüchtungsanlage. Die siebte erfindungsgemäße Kristallzüchtungsanlage entspricht der sechsten erfindungsgemäßen Kristallzüchtungsanlage und weist zusätzlich einen ersten 14 und einen zweiten optischen Pyrometerzugang 15 auf. Der erste optische Pyrometerzugang 14 durchgreift die zweite thermische Isolation 12 und ermöglicht dadurch eine pyrometrische Messung der Temperatur des Tiegeldeckels von oben. Der zweite optische Pyrometerzugang 15 durchgreift die erste thermische Isolation 5 sowie die untere Wärmequelle 11 und ermöglicht dadurch eine pyrometrische Messung der Temperatur des Tiegelbodens von unten. Vorzugsweise verlaufen der erste 14 und/oder der zweite optische Pyrometerzugang 15 entlang der Symmetrieachse des Wachstumstiegels.

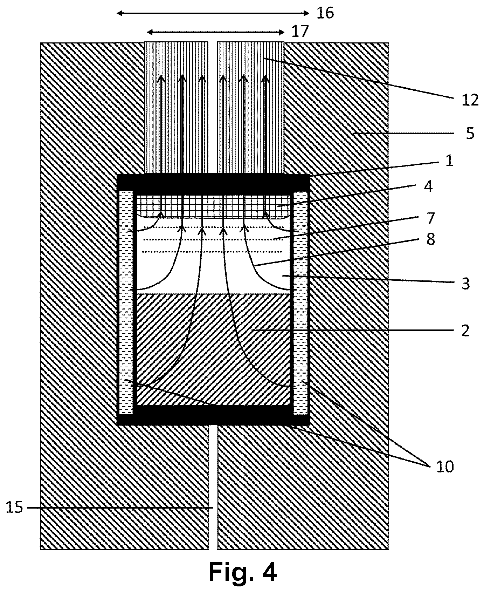

Fig. 4 zeigt eine schematische Darstellung einer achten erfindungsgemäßen Kristallzüchtungsanlage. Die achte erfindungsgemäße Kristallzüchtungsanlage entspricht der siebten erfindungsgemäßen Kristallzüchtungsanlage. Im Unterschied zu dieser ist jedoch die zweite thermische Isolation 12 oberhalb des Tiegeldeckels nicht vollflächig angeordnet. Im gezeigten Beispiel weist die zylinderförmige zweite thermische Isolation 12 einen Durchmesser von 100% des Durchmessers 17 des Nutzbereichs des Einkristalls 4, das heißt von 100% des Durchmessers des als Produkt anvisierten Einkristalls, auf. In einem anderen Beispiel kann die zweite thermische Isolation 12 einen Durchmesser von 80% des Außendurchmessers 16 des Wachstumstiegels aufweisen. Bei der achten erfindungsgemäßen Kristallzüchtungsanlage greift die erste thermische Isolation 5 in den oberhalb der von der zweiten thermischen Isolation 12 unbedeckten radial außenliegenden Ringfläche des Tiegeldeckels liegenden Bereich ein, so dass die zweite thermische Isolation 12 unmittelbar von der ersten thermischen Isolation 5 umgeben ist. Vorteilhafterweise kann durch das Anpassen des Durchmessers der zweiten thermischen Isolation 12 die Stärke des Wärmestroms 8 bzw. der axiale Temperaturgradient aus dem Wachstumstiegel eingestellt werden. Die achte erfindungsgemäße Kristallzüchtungsanlage kann zusätzlich wie die sechste bzw. die siebte erfindungsgemäße Kristallzüchtungsanlage eine untere Wärmequelle 11 aufweisen. Als Repräsentant für beliebige Wärmequellen ist - wie auch in den folgenden Figuren - das Bezugszeichen 10 eingefügt. Das Bezugszeichen 10 deutet darauf hin, dass untere Wärmequellen 11 und/oder seitliche Wärmequellen 13 vorgesehen sein können. Weiterhin umfasst das Bezugszeichen 10 induktive Heizeinheiten und/oder Widerstandsheizeinheiten.

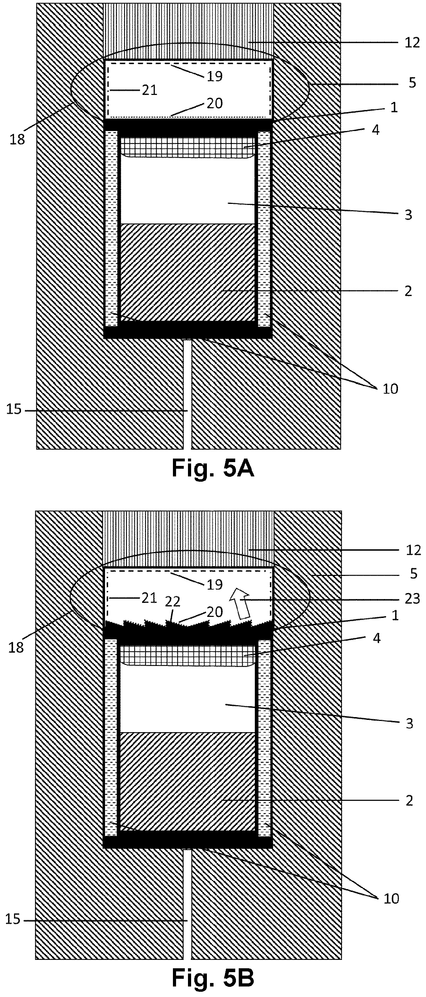

Fig. 5A zeigt eine schematische Darstellung einer neunten erfindungsgemäßen Kristallzüchtungsanlage. Die neunte erfindungsgemäße Kristallzüchtungsanlage weist zusätzlich einen zwischen dem Tiegeldeckel und der zweiten thermischen Isolation 12 angeordneten Hohlraum 18 auf. Der Hohlraum 18 ist also oben durch die untere Oberfläche 19 der zweiten thermischen Isolation 12, unten durch die obere Oberfläche 20 des Tiegeldeckels und seitlich durch die innere Oberfläche 21 der ersten thermischen Isolation 5 begrenzt. Die an den Hohlraum 18 angrenzenden Oberflächen 19, 20, 21 sind so ausgestaltet, dass sie einen angepassten Emissionsgrad ε bzw. unterschiedliche angepasste Emissionsgrade ε aufweisen. Im gezeigten Beispiel weisen die Oberflächen 19, 20, 21 den gleichen angepassten Emissionsgrad ε auf. Dazu sind die Oberflächen 19, 20, 21 mit einer Beschichtung von niedrigem Emissionsgrad ε versehen, z.B. mit TaC mit einem Emissionsgrad ε von etwa 0,3. Die Beschichtung insbesondere der Oberfläche 19 der zweiten thermischen Isolation 12 und der Oberfläche 20 des Tiegeldeckels wirkt sich besonders stark auf den axialen Temperaturgradienten im Hohlraum 18 aus. Das Aufbringen von Beschichtungen mit niedrigem Emissionsgrad ε führt zu einem erhöhten axialen Temperaturgradienten im Hohlraum 18. Ein erhöhter axialer Temperaturgradient im Hohlraum 18 wird physikalisch von einem reduzierten Wärmestrom 8 aus dem Wachstumstiegel begleitet. In der Summe führt dies dazu, dass im Tiegelinneren die gleichen thermischen Bedingungen erreicht werden können, wie es beim Verzicht auf die Beschichtung der an den Hohlraum 18 angrenzenden Oberflächen 19, 20, 21 möglich ist, allerdings bei einer um 10 % bis 20% niedrigeren Heizleistung. Auf diese Weise kann die Beschichtung zum Einsparen von elektrischer Energie genutzt werden.

In einer hier nicht gezeigten Modifikation kann der Hohlraum 18 seitlich durch einen Graphithohlzylinder und/oder oben mit einer Graphitscheibe begrenzt werden. Durch diese Graphitbauteile wird dem Hohlraum 18 eine größere mechanische Stabilität verliehen. Die Dicke der Graphitbauteile kann 10 mm betragen. Die Graphitbauteile können wiederum mit einer Beschichtung von niedrigem Emissionsgrad ε, z.B. mit TaC mit einem Emissionsgrad ε von etwa 0,3, versehen werden. Damit ergeben sich auch die oben genannten Vorteile.

Darüber hinaus kann die neunte erfindungsgemäße Kristallzüchtungsanlage wie die erste bis achte erfindungsgemäße Kristallzüchtungsanlage ausgestaltet sein. Insbesondere kann die neunte erfindungsgemäße Kristallzüchtungsanlage eine untere Wärmequelle 11 wie die sechste bzw. die siebte erfindungsgemäße Kristallzüchtungsanlage aufweisen.

Fig. 5B zeigt eine schematische Darstellung einer zehnten erfindungsgemäßen Kristallzüchtungsanlage. Die zehnte erfindungsgemäße Kristallzüchtungsanlage entspricht der neunten erfindungsgemäßen Kristallzüchtungsanlage und weist zusätzlich ein Relief 22 an der dem Hohlraum 18 zugewandten Oberfläche 20 des Tiegeldeckels auf. Diese Oberfläche kann außerdem wie oben erläutert beispielsweise durch eine Beschichtung in ihrem Emissionsgrad ε angepasst sein. Insbesondere kann sie mit einer Beschichtung mit niedrigem Emissionsgrad ε versehen sein, z.B. mit TaC mit einem Emissionsgrad ε von etwa 0,3.

Über die Einstellung des axialen Temperaturgradienten durch Variation des Emissionsgrad ε der Oberflächen 19, 20, 21 hinaus, ermöglicht die Aufprägung eines Reliefs die Einflussnahme auf die Richtung der Wärmestrahlung und damit auf den radialen Temperaturgradienten innerhalb des Hohlraums. In Fig. 5B ist dazu mit dem Bezugszeichen 23 die Richtung des Wärmestroms im Hohlraum 18 eingezeichnet. Die Richtung des Wärmestroms 23 im Hohlraum 18 ist durch den Einfluss des Reliefs 22 aus der axialen Richtung heraus leicht radial nach innen verkippt. Damit wird in kleinem Maß auch auf das Temperaturfeld im Wachstumstiegel, insbesondere im Bereich des wachsenden Einkristalls 4, Einfluss genommen. Dies ist für das Fine-Tuning des Temperaturfelds im Wachstumstiegel von Bedeutung. Dadurch kann ein kleiner radialer Temperaturgradient mit zugehörigen leicht konvex verlaufenden Isothermen an der Kristallwachstumsfront definiert eingestellt werden. Dadurch kann verhindert werden, dass das Temperaturfeld ausgehend von einem radialen Temperaturgradienten nahe 0 K/cm durch unbeabsichtigte Variationen in den Materialeigenschaften oder Geometrien der eingesetzten Graphitteile versehentlich in leicht konkave Isothermen an der Kristallwachstumsfront umschlägt, was den massiven Einbau von Kristallbaufehlern zur Folge hätte. Vorteilhafterweise kann also durch Vorsehen von leicht konvex verlaufenden Isothermen an der Kristallwachstumsfront das Kristallwachstum bei einer niedrigen Kristalldefektdichte stabilisiert werden.

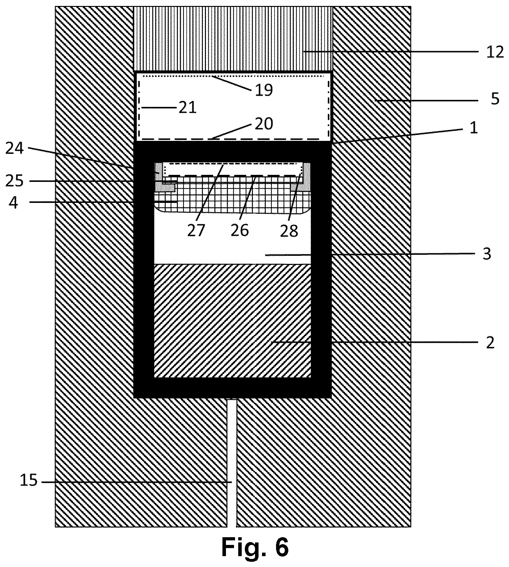

Fig. 6 zeigt eine schematische Darstellung einer elften erfindungsgemäßen Kristallzüchtungsanlage. Die elfte erfindungsgemäße Kristallzüchtungsanlage entspricht der neunten oder zehnten erfindungsgemäßen Kristallzüchtungsanlage und weist zusätzlich einen Keimhohlraum auf. Dazu ist der Einkristall 4 mit Hilfe einer Keimeinhängevorrichtung 24 derart angeordnet, dass der Keimhohlraum innerhalb des Wachstumstiegels zwischen dem Einkristall 4 und dem Tiegeldeckel gebildet wird. Die Keimeinhängevorrichtung 24 kann aus Graphit gebildet sein. Der in die Keimeinhängevorrichtung 24 eingehängte Kristallkeim, aus dem sich durch Anlagerung der Einkristall 4 entwickelt, ist mit dem Bezugszeichen 25 bezeichnet. Durch Vorsehen der Keimeinhängevorrichtung 24 wird der wachsende Einkristall 4 mechanisch vom Tiegelmaterial getrennt. Dadurch können thermisch induzierte mechanische Spannungen im Einkristall 4 aufgrund der unterschiedlichen thermischen Ausdehnungskoeffizienten des Einkristalls 4 und des aus Graphit gebildeten Wachstumstiegels bzw. des in der Regel aus dichtem Graphit gebildeten herkömmlichen Keimträgers vermieden werden.

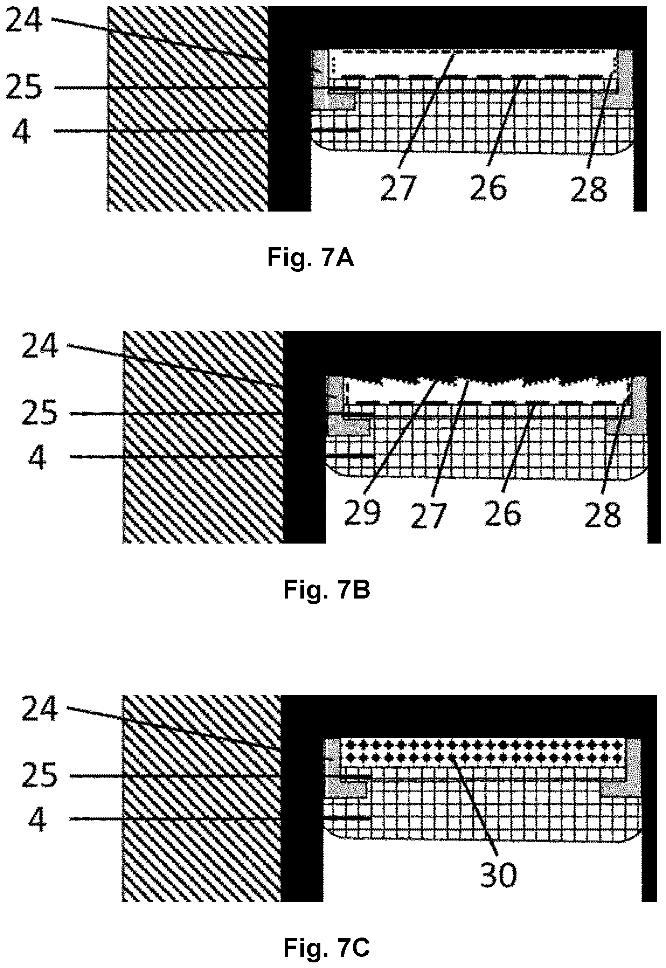

Die Figuren 7A bis 7C zeigen vergrößerte Detailansichten mit verschiedenen Ausgestaltungen der elften erfindungsgemäßen Kristallzüchtungsanlage. Der Keimhohlraum ist unten durch die obere Oberfläche 26 des Kristallkeims 25 bzw. des Einkristalls 4, oben durch die untere Oberfläche 27 des Tiegeldeckels und seitlich durch die innere Oberfläche 28 der der Keimeinhängevorrichtung 24 begrenzt. Die an den Keimhohlraum angrenzenden Oberflächen 26, 27, 28 sind so ausgestaltet, dass sie einen angepassten Emissionsgrad ε bzw. unterschiedliche angepasste Emissionsgrade ε aufweisen. Im gezeigten Beispiel weisen die an den Keimhohlraum angrenzende obere Oberfläche 26 des Kristallkeims 25 bzw. des Einkristalls 4 und die an den Keimhohlraum angrenzende untere Oberfläche 27 des Tiegeldeckels den gleichen angepassten Emissionsgrad ε auf. Dazu sind die Oberflächen 26, 27 mit einer Beschichtung von niedrigem Emissionsgrad ε versehen, z.B. mit TaC mit einem Emissionsgrad ε von etwa 0,3. Zusätzlich kann auch die an den Keimhohlraum angrenzende innere Oberfläche 28 der Keimeinhängevorrichtung 24 den gleichen angepassten Emissionsgrad ε aufweisen und insbesondere mit einer Beschichtung von niedrigem Emissionsgrad ε versehen sein, z.B. mit TaC mit einem Emissionsgrad ε von etwa 0,3. Die Beschichtung insbesondere der oberen Oberfläche 26 des Kristallkeims 25 bzw. des Einkristalls 4 und die untere Oberfläche 27 des Tiegeldeckels wirkt sich auf den axialen Temperaturgradienten im Keimhohlraum aus. Das Aufbringen von Beschichtungen mit niedrigem Emissionsgrad ε führt zu einem erhöhten axialen Temperaturgradienten im Keimhohlraum. Ein erhöhter axialer Temperaturgradient im Keimhohlraum führt zu einer höheren Übersättigung der Wachstumsspezies an der Wachstumsfront des wachsenden Einkristalls 4. Eine solche Übersättigung ist vorteilhaft bei der Herstellung von SiC mit kubischem Polytyp, das heißt bei der Herstellung von 3C-SiC.

In einer alternativen Ausgestaltung sind die an den Keimhohlraum angrenzende obere Oberfläche 26 des Kristallkeims 25 bzw. des Einkristalls 4 und die an den Keimhohlraum angrenzende untere Oberfläche 27 des Tiegeldeckels mit einer Beschichtung mit hohem Emissionsgrad ε versehen, z.B. mit C mit einem Emissionsgrad ε von etwa 0,9. Das Aufbringen von Beschichtungen mit hohem Emissionsgrad ε führt zu einem verringerten axialen Temperaturgradienten im Keimhohlraum. Ein verringerter axialer Temperaturgradient im Keimhohlraum führt zu einer geringen Übersättigung der Wachstumsspezies an der Wachstumsfront des wachsenden Einkristalls 4. Das ist vorteilhaft bei der Herstellung von SiC mit hexagonalem Polytyp, beispielsweise bei der der Herstellung von 6H-SiC und insbesondere bei der der Herstellung von 4H-SiC.

Je nach Beschichtung der an den Keimhohlraum angrenzenden Oberflächen 26, 27 kann also die Wärme unterschiedlich stark abgeführt werden. Der aus dem Wachstumstiegel hinaus gerichtete Wärmestrom lässt sich dadurch präzise einstellen.

Bei der in Fig. 7B dargestellten Ausgestaltung ist zusätzlich an der an den Keimhohlraum angrenzenden unteren Oberfläche 27 des Tiegeldeckels ein weiteres Relief 29 vorgesehen. Dadurch wird Einfluss auf den radialen Temperaturgradienten genommen. Dadurch kann ein kleiner radialer Temperaturgradient mit zugehörigen leicht konvex verlaufenden Isothermen an der Kristallwachstumsfront des wachsenden Einkristalls 4 definiert eingestellt werden. Dadurch kann verhindert werden, dass das Temperaturfeld ausgehend von einem radialen Temperaturgradienten nahe 0 K/cm durch unbeabsichtigte Variationen in den Materialeigenschaften oder Geometrien der eingesetzten Graphitteile versehentlich in leicht konkave Isothermen an der Kristallwachstumsfront umschlägt, was den massiven Einbau von Kristallbaufehlern zur Folge hätte. Vorteilhafterweise kann also durch Vorsehen von leicht konvex verlaufenden Isothermen an der Kristallwachstumsfront das Kristallwachstum bei einer niedrigen Kristalldefektdichte stabilisiert werden.

Bei der in Fig. 7C dargestellten Ausgestaltung ist zusätzlich im Keimhohlraum eine Keimhohlraumfüllung 30 vorgesehen. Im gezeigten Beispiel ist der Keimhohlraum vollständig mit der Keimhohlraumfüllung 30 ausgefüllt. Die Keimhohlraumfüllung 30 ist ein temperaturstabiler und mit SiC chemisch inerter Feststoff, z.B. ein SiC-Pulver. Die Keimhohlraumfüllung 30 ist derart vorgesehen, dass sie den Abtransport der Wärme vom Einkristall 4 zum Tiegeldeckel nicht behindert. Vorteilhafterweise wird durch das Vorsehen der Keimhohlraumfüllung 30 eine weitere Möglichkeit bereitgestellt, einen definierten Abtransport der Kristallisationswärme zu gewährleiten.

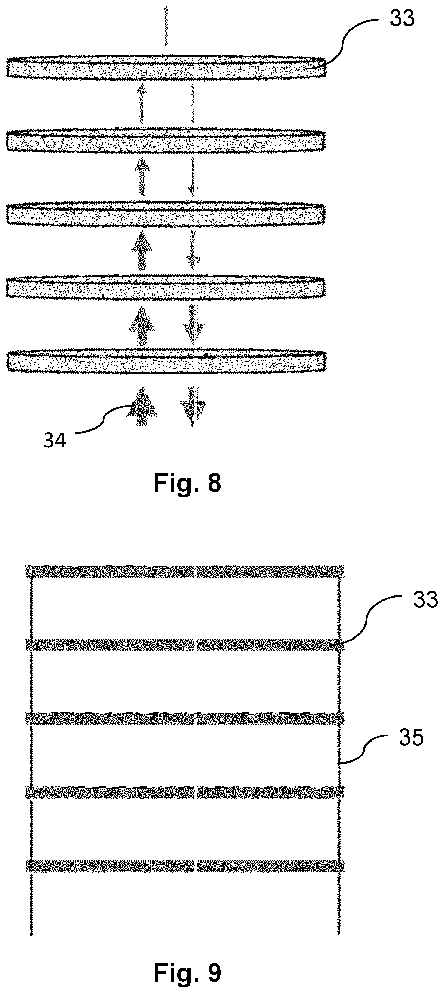

Fig. 8 zeigt eine schematische dreidimensionale Ansicht einer zweiten thermischen Isolation als Abfolge aus fünf Platten 33. Der sich unterhalb der Abfolge der Platten 33 befindende Wachstumstiegel ist dabei nicht dargestellt. Die Platten 33 weisen beispielsweise jeweils eine Dicke von 2 mm auf. Benachbarte Platten 33 haben beispielsweise einen Abstand von 10 mm. Die Platten 33 sind aus einem hochtemperaturstabilen Material gebildet, z.B. Graphit. Jede einzelne Platte 33 reflektiert vorzugsweise einen möglichst hohen Anteil der auf sie auftreffenden Wärmestrahlung 34 und transmittiert vorzugsweise einen möglichst niedrigen Anteil der auf sie auftreffenden Wärmestrahlung 34. Die Platten 33 wirken also als Strahlungsschilde. Die transmittierte Wärmestrahlung 34 nimmt von Platte 33 zu Platte 33 ab. Entsprechend herrscht oberhalb der Abfolge der Platten 33 eine wesentlich geringere Temperatur als unterhalb der Abfolge der Platten 33.

Die Stärke der thermischen Isolation wird im Wesentlichen von der Anzahl der Platten 33 und dem jeweiligen Emissionsgrad der Oberflächen der Platten 33 bestimmt.

Der Wachstumstiegel wird vorzugsweise in einem Temperaturbereich von T = 1500°C bis 2500°C betrieben. In diesem Temperaturbereich dominiert die Wärmeübertragung durch Wärmestrahlung. Um mit Hilfe der Anordnung mehrerer Platten 33 die gleiche Hochtemperatur-Isolation eines Graphitschaums oder Graphitfilzes in diesem Temperaturbereich zu erhalten sind beispielsweise geeignet:
Drei bis fünf Platten mit einem beidseitigen Emissionsgrad von 0,3. Die Platten 33 sind dazu z.B. aus Graphit mit einer TaC-Beschichtung oder aus TaC.

Fünf bis acht Platten mit einem beidseitigen Emissionsgrad von 0.7. Die Platten 33 weisen dazu z.B. eine glänzende Graphitoberfläche auf.

Dazu sind verschiedene Variationen möglich. Der Emissionsgrad aufeinanderfolgender Platten 33 kann variieren. Die Oberseite und die Unterseite einer Platte 33 oder mehrerer Platten 33 können sich im Emissionsgrad unterscheiden.

Fig. 9 zeigt einen mittigen zweidimensionalen Schnitt durch die in Fig. 8 gezeigte Abfolge aus fünf Platten 33 in einer ersten Ausgestaltung. Dabei sind die Platten 33 durch in einem radial außenliegenden Bereich der Platten 33 angeordnete Abstandhalter voneinander beabstandet. Die Abstandhalter sind dabei als dünne Stifte 35 ausgestaltet.

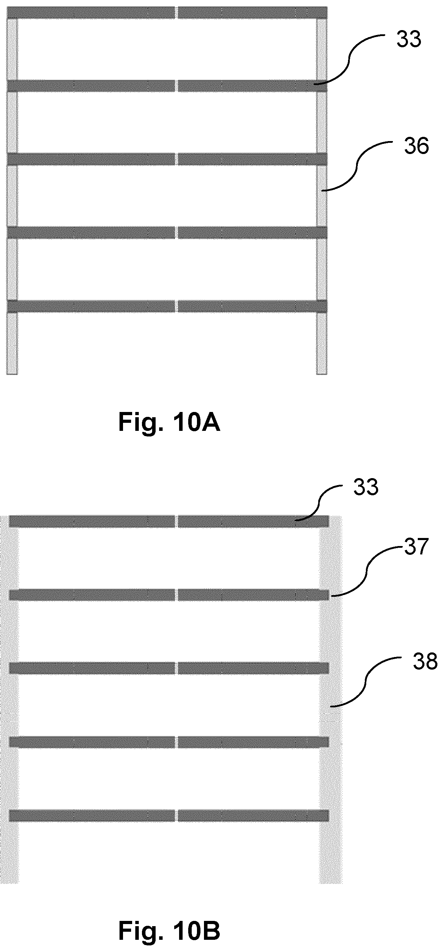

Fig. 10A zeigt einen mittigen zweidimensionalen Schnitt durch die in Fig. 8 gezeigte Abfolge aus fünf Platten in einer zweiten Ausgestaltung. Auch hier sind die Platten 33 durch in einem radial außenliegenden Bereich der Platten 33 angeordnete Abstandhalter voneinander beabstandet. Die Abstandhalter sind in dieser Ausgestaltung als Ringe 36 ausgeführt. Dazu ist jeweils abwechselnd ein Ring 36 und eine Platte 33 aufeinander angeordnet. Fig. 10B zeigt einen mittigen zweidimensionalen Schnitt durch die in Fig. 8 gezeigte Abfolge aus fünf Platten in einer dritten Ausgestaltung. Hier greifen die Platten 33 mit einem radial außenliegenden Bereich in Aufnahmenuten 37 eines ringförmigen Aufnahmekörpers 38 ein. Die Ringe 36 und der Aufnahmekörper 38 sind vorzugsweise aus thermisch isolierendem Material hergestellt, beispielsweise aus Graphitschaum oder Filz.

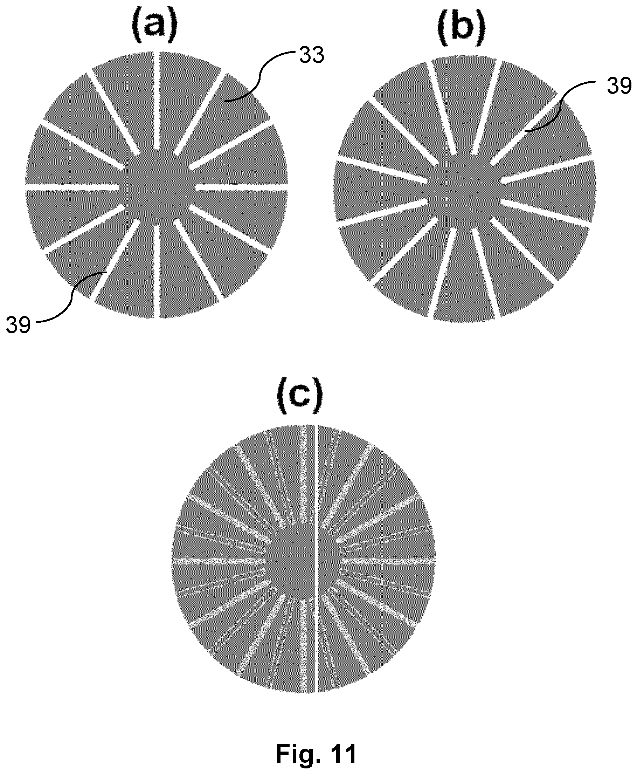

Fig. 11 zeigt schematische Darstellungen von jeweils mit länglichen Einschnitten 39 versehenen Platten. Die Einschnitte 39 verlaufen jeweils in radialer Richtung ausgehend von einem äußeren Umfang der Platten 33. Die Einschnitte 39 dringen dabei nicht in einen radial innenliegenden Bereich der Platten ein und treffen sich daher nicht. Die Platten 33 weisen jeweils zwölf Einschnitte 39 mit jeweils einem Winkelabstand von 30° zueinander auf. Die als (a) und (b) gezeigten Platten 33 sind zueinander um 15° gedreht. Dadurch sind die Einschnitte 39 bei der in (c) vorgenommenen übereinanderliegenden Anordnung der in (a) und (b) gezeigten Platten 33 zueinander versetzt.

Durch Vorsehen der Einschnitte 39 kann vorteilhafterweise die induktive Einkopplung von Induktionsleistung in die Platten 33 vermieden oder zumindest stark reduziert werden. Durch die verdrehte vertikale Anordnung kann eine eventuell störende vertikale Durchstrahlung von Wärme durch die Einschnitte 39 unterbunden werden.

### Bezugszeichenliste

- 1: Tiegelwand
- 2: Quellenmaterial
- 3: Gasraum
- 4: Einkristall
- 5: erste thermische Isolation
- 6: induktive Heizeinheit
- 7: Isotherme
- 8: Wärmestrom
- 9: Widerstandsheizeinheit
- 10: beliebige Wärmequelle
- 11: untere Wärmequelle
- 12: zweite thermische Isolation
- 13: seitliche Wärmequelle
- 14: erster optischer Pyrometerzugang
- 15: zweiter optischer Pyrometerzugang
- 16: Außendurchmesser des Wachstumstiegels
- 17: Durchmesser des Nutzbereichs des Einkristalls
- 18: Hohlraum
- 19: untere Oberfläche der zweiten thermischen Isolation
- 20: obere Oberfläche des Tiegeldeckels
- 21: innere Oberfläche der ersten thermischen Isolation
- 22: Relief
- 23: Richtung des Wärmestroms im Hohlraum
- 24: Keimeinhängevorrichtung
- 25: Kristallkeim
- 26: obere Oberfläche des Kristallkeims bzw. des Einkristalls
- 27: untere Oberfläche des Tiegeldeckels
- 28: innere Oberfläche der der Keimeinhängevorrichtung
- 29: weiteres Relief
- 30: Keimhohlraumfüllung
- 31: Suszeptor
- 32: materialfreier Bereich
- 33: Platte
- 34: Wärmestrahlung
- 35: Stift
- 36: Ring
- 37: Aufnahmenut
- 38: Aufnahmekörper
- 39: Einschnitt

## Patentansprüche

1. Kristallzüchtungsanlage umfassend einen Wachstumstiegel zur Herstellung und/oder Vergrößerung eines Einkristalls (4),
wobei die Kristallzüchtungsanlage eine erste thermische Isolation (5) mit einer ersten Wärmeleitfähigkeit und eine zweite thermische Isolation (12) mit einer zweiten Wärmeleitfähigkeit aufweist,
wobei der Wachstumstiegel einen Tiegelboden, eine Tiegelseitenwand und
einen Tiegeldeckel aufweist, wobei die Tiegelseitenwand mittelbar oder
unmittelbar von der ersten thermischen Isolation (5) umgeben ist, wobei die zweite thermische Isolation (12) mittelbar oder unmittelbar oberhalb des Tiegeldeckels angeordnet ist,
wobei die zweite Wärmeleitfähigkeit größer als die erste Wärmeleitfähigkeit ist, und wobei die zweite Wärmeleitfähigkeit in einem Bereich von 2 bis 50 W/(m*K) bei Raumtemperatur liegt.

2. Kristallzüchtungsanlage nach Anspruch 1, wobei ein im Wachstumstiegel vorgesehenes Quellenmaterial (2) aufheizbar, verdampfbar und abscheidbar ist, wobei als Quellenmaterial (2) vorzugsweise SiC, besonders bevorzugt ein SiC-Pulver und/oder ein SiC-Volumenkörper, vorgesehen ist,
und/oder
wobei die erste thermische Isolation (5) zusätzlich mittelbar oder unmittelbar unterhalb des Tiegelbodens angeordnet ist, so dass die erste thermische Isolation (5) vorzugsweise als unten geschlossener Hohlzylinder ausgebildet ist.

3. Kristallzüchtungsanlage nach einem der vorangehenden Ansprüche, wobei die erste Wärmeleitfähigkeit in einem Bereich von 0,05 bis 5 W/(m*K), vorzugsweise in einem Bereich von 0,1 bis 2 W/(m*K), besonders bevorzugt bei 0,5 W/(m*K) liegt und/oder wobei die zweite Wärmeleitfähigkeit in einem Bereich von 5 bis 20 W/(m*K), vorzugsweise bei 10 W/(m*K) liegt.

4. Kristallzüchtungsanlage nach einem der vorangehenden Ansprüche, wobei die Kristallzüchtungsanlage einen zwischen Tiegeldeckel und der zweiten thermischen Isolation (12) angeordneten Hohlraum (18) umfasst,
wobei die an den Hohlraum (18) angrenzende Oberfläche der ersten thermischen Isolation (5) vorzugsweise einen vorbestimmten ersten Emissionsgrad (ε), und/oder die an den Hohlraum (18) angrenzende Oberfläche der zweiten thermischen Isolation (12) vorzugsweise einen vorbestimmten zweiten Emissionsgrad (ε) und/oder die an den Hohlraum (18) angrenzende Oberfläche des Tiegeldeckels vorzugsweise einen vorbestimmten dritten Emissionsgrad (ε) aufweist, wobei der erste, zweite und/oder dritte Emissionsgrad (ε) bevorzugt auf einen Bereich von zwischen 0,05 und 0,5, besonders bevorzugt auf einen Bereich zwischen 0,2 und 0,4, insbesondere auf etwa 0,3 eingestellt ist,
und/oder
wobei die an den Hohlraum (18) angrenzende Oberfläche des Tiegeldeckels und/oder die an den Hohlraum (18) angrenzende Oberfläche der ersten thermischen Isolation (5) und/oder die an den Hohlraum (18) angrenzende Oberfläche der zweiten thermischen Isolation (12) vorzugsweise ein vorbestimmtes Relief (22) aufweist.

5. Kristallzüchtungsanlage nach einem der vorangehenden Ansprüche, wobei der Einkristall (4) mit Hilfe einer Keimeinhängevorrichtung (24) angeordnet ist, und wobei die Kristallzüchtungsanlage einen zwischen dem Einkristall (4) und dem Tiegeldeckel innerhalb des Wachstumstiegels angeordneten Keimhohlraum umfasst,
wobei die an den Keimhohlraum angrenzende Oberfläche der Keimeinhängevorrichtung (24) vorzugsweise einen vorbestimmten vierten Emissionsgrad (ε), und/oder die an den Keimhohlraum angrenzende Oberfläche des Tiegeldeckels vorzugsweise einen vorbestimmten fünften Emissionsgrad (ε) und/oder die an den Keimhohlraum angrenzende Oberfläche des Einkristalls (4) vorzugsweise einen vorbestimmten sechsten Emissionsgrad (ε) aufweist,
und/oder
wobei die an den Keimhohlraum angrenzende Oberfläche des Tiegeldeckels und/oder die an den Keimhohlraum angrenzende Oberfläche der Keimeinhängevorrichtung (24) und/oder die an den Keimhohlraum angrenzende Oberfläche des Einkristalls (4) vorzugsweise ein vorbestimmtes weiteres Relief (29) aufweist,
und/oder
wobei der Keimhohlraum vorzugsweise mit einem Feststoff ausgefüllt ist, wobei der Feststoff aus SiC-Pulver, aus einem polykristallinen oder einkristallinem SiC-Kristall, und/oder aus porösem oder massivem Graphit besteht.

6. Kristallzüchtungsanlage nach einem der vorangehenden Ansprüche, wobei die Kristallzüchtungsanlage eine Heizvorrichtung zum Aufheizen des Wachstumstiegels umfasst, wobei die Heizvorrichtung vorzugsweise eine induktive Heizeinheit (6) und/oder eine Widerstandsheizeinheit (9) umfasst, wobei die Heizvorrichtung vorzugsweise zwischen dem Tiegelboden und der ersten thermischen Isolation (5) und/oder zwischen der Tiegelseitenwand und der ersten thermischen Isolation (5) angeordnet ist.

7. Kristallzüchtungsanlage nach einem der vorangehenden Ansprüche, wobei die Kristallzüchtungsanlage einen ersten (14) und/oder einen zweiten (15) Pyrometerzugang umfasst,
wobei der erste Pyrometerzugang (14) die zweite thermische Isolation (12) bis zum Tiegeldeckel vorzugsweise entlang der Rotationsachse des Wachstumstiegels durchgreift, und/oder
wobei der zweite Pyrometerzugang (15) die erste thermische Isolation (5) und/oder die Heizvorrichtung bis zum Tiegelboden vorzugsweise entlang der Rotationsachse des Wachstumstiegels durchgreift.

8. Kristallzüchtungsanlage nach einem der vorangehenden Ansprüche, wobei mittelbar oder unmittelbar oberhalb einer radial außenliegenden Ringfläche des Tiegeldeckels die erste thermische Isolation (5) angeordnet ist, und/oder
wobei der Tiegelboden, die Tiegelseitenwand und/oder der Tiegeldeckel des Wachstumstiegels aus Graphit und/oder TaC und/oder beschichtetem Graphit, insbesondere aus pyrolytisch mit Kohlenstoff beschichtetem Graphit und/oder aus mit Ta und/oder TaC beschichtetem Graphit, gebildet ist.

9. Kristallzüchtungsanlage nach einem der vorangehenden Ansprüche, wobei das Quellenmaterial (2) im Wachstumstiegel in Abhängigkeit von Temperaturgradienten verdampfbar, und/oder transportierbar und/oder abscheidbar ist, wobei die Temperaturgradienten im Wachstumstiegel gezielt einstellbar sind.

10. Kristallzüchtungsanlage nach einem der vorangehenden Ansprüche, wobei die Kristallzüchtungsanlage zur gezielten Einstellung von Temperaturgradienten im Wachstumstiegel ausgebildet ist,
wobei die Temperaturgradienten durch die Ausgestaltung der ersten (5) und/oder zweiten thermischen Isolation (12) derart einstellbar sind, dass die Isothermen (7) einen konvexen Verlauf aufweisen.

11. Kristallzüchtungsanlage nach einem der vorangehenden Ansprüche, wobei die Temperaturgradienten im Wachstumstiegel durch die Heizvorrichtung einstellbar sind.

12. Kristallzüchtungsanlage nach einem der vorangehenden Ansprüche, wobei die erste thermische Isolation (5) aus einem ersten Isolationsmaterial, insbesondere einem ersten Hochtemperaturisolationsmaterial besteht oder ein solches aufweist, vorzugsweise einem Feststoff, besonders bevorzugt aus Graphitfilz und/oder Graphitschaum, und/oder
wobei die zweite thermische Isolation (12) aus einem zweiten Isolationsmaterial, insbesondere einem zweiten Hochtemperaturisolationsmaterial besteht oder ein solches aufweist, vorzugsweise einem Feststoff, besonders bevorzugt aus Graphitschaum und/oder porösen Graphit.

13. Kristallzüchtungsanlage nach einem der vorangehenden Ansprüche, wobei die zweite thermische Isolation (12) aus einer Abfolge mehrerer jeweils zueinander beabstandeter Platten (33) gebildet ist, wobei die Platten (33) vorzugsweise kreisscheibenförmig sind, und/oder
wobei die zweite thermische Isolation (12) vorzugsweise aus zwei bis zehn, besonders bevorzugt aus drei bis fünf, Platten (33) gebildet ist, und/oder wobei die Platten (33) vorzugsweise aus einem hochtemperaturstabilen Material gebildet sind,
wobei das hochtemperaturstabile Material besonders bevorzugt Graphit, beschichtetes Graphit, Metallkarbid und/oder hochtemperaturschmelzendes Metall ist, und/oder
wobei die Platten (33) vorzugsweise jeweils eine Dicke zwischen 0,1 und 10 mm, besonders bevorzugt 0,5 bis 3 mm, aufweisen, und/oder wobei aufeinanderfolgende Platten (33) vorzugsweise jeweils einen Abstand im Bereich von 1 bis 50 mm, besonders bevorzugt 5 bis 20 mm, aufweisen,
und/oder
wobei die Platten (33) vorzugsweise jeweils mehrere längliche Einschnitte (39) aufweisen.

14. Kristallzüchtungsanlage nach Anspruch 13,
wobei die Platten (33) an ihren Oberflächen einen definiert eingestellten Emissionsgrad aufweisen, vorzugsweise einen Emissionsgrad von höchstens 0,4 oder einen Emissionsgrad von mindestens 0,6, besonders bevorzugt einen Emissionsgrad von höchstens 0,3 oder einen Emissionsgrad von mindestens 0,7,
wobei sich die Emissionsgrade aufeinanderfolgender Platten (33) vorzugsweise unterscheiden, und/oder wobei sich die Emissionsgrade an einer Unterseite und an einer Oberseite einer oder mehrerer Platten (33) vorzugsweise unterscheiden.

15. Verfahren zur Herstellung und/oder Vergrößerung eines Einkristalls (4) durch Aufheizen, Verdampfen und Abscheiden eines Quellenmaterials im Wachstumstiegel einer Kristallzüchtungsanlage nach einem der Ansprüche 1 bis 14,
wobei das Quellenmaterial (2) in Abhängigkeit von Temperaturgradienten verdampft, und/oder transportiert und/oder abgeschieden wird, wobei die Temperaturgradienten gezielt eingestellt werden,
wobei der Wachstumstiegel einen Tiegelboden, eine Tiegelseitenwand und einen Tiegeldeckel aufweist, wobei die Tiegelseitenwand mittelbar oder unmittelbar von einer ersten thermischen Isolation (5) mit einer ersten Wärmeleitfähigkeit umgeben ist, wobei oberhalb des Tiegeldeckels mittelbar oder unmittelbar eine zweite thermische Isolation (12) mit einer zweiten Wärmeleitfähigkeit angeordnet ist, wobei die zweite Wärmeleitfähigkeit größer als die erste Wärmeleitfähigkeit ist, wobei die zweite Wärmeleitfähigkeit in einem Bereich von 2 bis 50 W/(m*K) bei Raumtemperatur liegt, und
wobei die Temperaturgradienten durch die Ausgestaltung der ersten und/oder zweiten thermischen Isolation (12) derart eingestellt werden, dass die Isothermen (7) einen konvexen Verlauf aufweisen.

## Claims

1. A crystal growing unit comprising a crucible for producing and/or enlarging a single crystal (4),
wherein the crystal growing unit has a first thermal insulation (5) with a first thermal conductivity and a second thermal insulation (12) with a second thermal conductivity,
wherein the crucible has a crucible base, a crucible side wall and a crucible cover, wherein the crucible side wall is indirectly or directly surrounded by the first thermal insulation (5), wherein the second thermal insulation (12) is arranged indirectly or directly above the crucible cover,
wherein the second thermal conductivity is greater than the first thermal conductivity,
and wherein the second thermal conductivity lies in a range of from 2 to 50 W/(m*K) at room temperature.

2. Crystal growth unit according to claim 1, wherein a source material (2) provided in the crucible can be heated, evaporated and deposited, wherein preferably SiC, particularly preferably an SiC powder and/or an SiC solid, is provided as source material (2),
and/or
wherein the first thermal insulation (5) is additionally arranged indirectly or directly below the crucible base, with the result that the first thermal insulation (5) is preferably formed as a hollow cylinder closed at the bottom.

3. Crystal growing unit according to one of the preceding claims,
wherein the first thermal conductivity lies in a range of from 0.05 to 5 W/(m*K), preferably in a range of from 0.1 to 2 W/(m*K), particularly preferably at 0.5 W/(m*K) and/or wherein the second thermal conductivity lies in a range of from 5 to 20 W/(m*K), preferably at 10 W/(m*K).

4. Crystal growing unit according to one of the preceding claims,
wherein the crystal growing unit comprises a cavity (18) arranged between the crucible cover and the second thermal insulation (12),
wherein the surface of the first thermal insulation (5) adjoining the cavity (18) preferably has a predetermined first emissivity (ε), and/or the surface of the second thermal insulation (12) adjoining the cavity (18) preferably has a predetermined second emissivity (ε), and/or the surface of the crucible cover adjoining the cavity (18) preferably has a predetermined third emissivity (ε), wherein the first, second and/or third emissivity (ε) is preferably set in a range of between 0.05 and 0.5, particularly preferably in a range of between 0.2 and 0.4, in particular to about 0.3,
and/or
wherein the surface of the crucible cover adjoining the cavity (18) and/or the surface of the first thermal insulation (5) adjoining the cavity (18) and/or the surface of the second thermal insulation (12) adjoining the cavity (18) preferably has a predetermined relief (22).

5. Crystal growing unit according to one of the preceding claims,
wherein the single crystal (4) is arranged with the aid of a nucleus suspension device (24), and wherein the crystal growing unit comprises a nucleus cavity arranged within the crucible between the single crystal (4) and the crucible cover,
wherein the surface of the nucleus suspension device (24) adjoining the nucleus cavity preferably has a predetermined fourth emissivity (ε), and/or the surface of the crucible cover adjoining the nucleus cavity preferably has a predetermined fifth emissivity (ε), and/or the surface of the single crystal (4) adjoining the nucleus cavity preferably has a predetermined sixth emissivity (ε), and/or
wherein the surface of the crucible cover adjoining the nucleus cavity and/or the surface of the nucleus suspension device (24) adjoining the nucleus cavity and/or the surface of the single crystal (4) adjoining the nucleus cavity preferably has a predetermined further relief (29),
and/or
wherein the nucleus cavity is preferably filled with a solid material, wherein the solid material consists of SiC powder, a polycrystalline or monocrystalline SiC crystal, and/or porous or solid graphite.

6. Crystal growing unit according to one of the preceding claims,
wherein the crystal growing unit comprises a heating device for heating the crucible, wherein the heating device preferably comprises an induction-heating unit (6) and/or a resistance-heating unit (9),
wherein the heating device is preferably arranged between the crucible base and the first thermal insulation (5) and/or between the crucible side wall and the first thermal insulation (5).

7. Crystal growing unit according to one of the preceding claims,
wherein the crystal growing unit comprises a first (14) and/or a second (15) pyrometer access,
wherein the first pyrometer access (14) penetrates the second thermal insulation (12) up to the crucible cover, preferably along the axis of rotation of the crucible, and/or
wherein the second pyrometer access (15) penetrates the first thermal insulation (5) and/or the heating device up to the crucible base, preferably along the axis of rotation of the crucible.

8. Crystal growing unit according to one of the preceding claims,
wherein the first thermal insulation (5) is arranged indirectly or directly above a radially outer annular surface of the crucible cover,
and/or
wherein the crucible base, the crucible side wall and/or the crucible cover of the crucible is formed of graphite and/or TaC and/or coated graphite, in particular graphite pyrolytically coated with carbon and/or graphite coated with Ta and/or TaC.

9. Crystal growing unit according to one of the preceding claims,
wherein the source material (2) in the crucible can, depending on temperature gradients, be evaporated and/or transported and/or deposited, wherein the temperature gradients can be set in a targeted manner in the crucible.

10. Crystal growing unit according to one of the preceding claims,
wherein the crystal growing unit is formed for the targeted setting of temperature gradients in the crucible,
wherein the temperature gradients can be set through the design of the first (5) and/or second thermal insulation (12) in such a way that the isotherms (7) have a convex progression.

11. Crystal growing unit according to one of the preceding claims,
wherein the temperature gradients in the crucible can be set by the heating device.

12. Crystal growing unit according to one of the preceding claims,
wherein the first thermal insulation (5) consists of or contains a first insulation material, in particular a first high-temperature insulation material, preferably a solid material, particularly preferably graphite felt and/or graphite foam, and/or wherein the second thermal insulation (12) consists of or contains a second insulation material, in particular a second high-temperature insulation material, preferably a solid material, particularly preferably graphite foam and/or porous graphite.

13. Crystal growing unit according to one of the preceding claims,
wherein the second thermal insulation (12) is formed of a series of several sheets (33) spaced apart from each other in each case, wherein the sheets (33) are preferably circular disk-shaped, and/or
wherein the second thermal insulation (12) is preferably formed of from two to ten, particularly preferably from three to five, sheets (33), and/or wherein the sheets (33) are preferably formed of a material with high temperature stability,
wherein the material with high temperature stability is particularly preferably graphite, coated graphite, metal carbide and/or metal with a high melting temperature, and/or
wherein the sheets (33) preferably in each case have a thickness of between 0.1 and 10 mm, particularly preferably 0.5 to 3 mm, and/or
wherein successive sheets (33) preferably in each case have a spacing in the range of from 1 to 50 mm, particularly preferably 5 to 20 mm, and/or
wherein the sheets (33) preferably in each case have several elongated incisions (39).

14. Crystal growing unit according to claim 13,
wherein the sheets (33) have a defined emissivity on their surfaces, preferably an emissivity of at most 0.4 or an emissivity of at least 0.6, particularly preferably an emissivity of at most 0.3 or an emissivity of at least 0.7,
wherein the emissivities of successive sheets (33) preferably differ, and/or
wherein the emissivities on a bottom side and on a top side of one or more sheets (33) preferably differ.

15. Method for producing and/or enlarging a single crystal (4) by heating, evaporating and depositing a source material in the crucible of a crystal growth unit according to one of claims 1 to 14,
wherein the source material (2) is, depending on temperature gradients, evaporated and/or transported and/or deposited, wherein the temperature gradients are set in a targeted manner,
wherein the crucible has a crucible base, a crucible side wall and a crucible cover, wherein the crucible side wall is indirectly or directly surrounded by a first thermal insulation (5) with a first thermal conductivity, wherein a second thermal insulation (12) with a second thermal conductivity is arranged indirectly or directly above the crucible cover, wherein the second thermal conductivity is greater than the first thermal conductivity, wherein the second thermal conductivity lies in a range of from 2 to 50 W/(m*K) at room temperature, and
wherein the temperature gradients are set through the design of the first and/or second thermal insulation (12) in such a way that the isotherms (7) have a convex progression.

## Revendications

1. Installation de croissance de cristaux comprenant un creuset de croissance pour produire et/ou agrandir un monocristal (4),
l'installation de croissance de cristaux comprenant une première isolation thermique (5) ayant une première conductivité thermique et une seconde isolation thermique (12) ayant une seconde conductivité thermique,
le creuset de croissance présentant un fond de creuset, une paroi latérale de creuset et un couvercle de creuset, la paroi latérale de creuset étant entourée directement ou indirectement par la première isolation thermique (5), la deuxième isolation thermique (12) étant disposée directement ou indirectement au-dessus du couvercle de creuset,
dans laquelle la seconde conductivité thermique est supérieure à la première conductivité thermique,
et dans laquelle la seconde conductivité thermique se situe dans une plage de 2 à 50 W/(m*K) à température ambiante.

2. Installation de croissance de cristaux selon la revendication 1, dans laquelle un matériau source (2) prévu dans le creuset de croissance peut être chauffé, évaporé et déposé, le matériau source (2) étant de préférence du SiC, de manière particulièrement préférée une poudre de SiC et/ou un corps volumique de SiC,
et/ou
dans laquelle la première isolation thermique (5) est en outre disposée directement ou indirectement sous le fond du creuset, de sorte que la première isolation thermique (5) est de préférence conçue comme un cylindre creux fermé en bas.

3. Installation de croissance de cristaux selon l'une des revendications précédentes,
dans laquelle la première conductivité thermique se situe dans une plage de 0,05 à 5 W/(m*K), de préférence dans une plage de 0,1 à 2 W/(m*K), de manière particulièrement préférée à 0,5 W/(m*K) et/ou dans laquelle la deuxième conductivité thermique se situe dans une plage de 5 à 20 W/(m*K), de préférence à 10 W/(m*K).

4. Installation de croissance de cristaux selon l'une des revendications précédentes,
l'installation de croissance de cristaux comprenant une cavité (18) disposée entre le couvercle de creuset et la deuxième isolation thermique (12),
la surface de la première isolation thermique (5) adjacente à la cavité (18) présentant de préférence une première émissivité (ε) prédéterminée, et/ou la surface de la deuxième isolation thermique (12) adjacente à la cavité (18) présentant de préférence une deuxième émissivité (ε) prédéterminée, et/ou la surface du couvercle de creuset adjacente à la cavité (18) présentant de préférence une troisième émissivité (ε) prédéterminée, la première, la deuxième et/ou la troisième émissivité (ε) étant de préférence réglée sur une plage comprise entre 0,05 et 0,5, de manière particulièrement préférée sur une plage comprise entre 0,2 et 0,4, en particulier sur environ 0,3,
et/ou
dans laquelle la surface du couvercle de creuset adjacente à la cavité (18) et/ou la surface de la première isolation thermique (5) adjacente à la cavité (18) et/ou la surface de la deuxième isolation thermique (12) adjacente à la cavité (18) présente de préférence un relief prédéterminé (22).

5. Installation de croissance de cristaux selon l'une des revendications précédentes,
dans laquelle le monocristal (4) est disposé à l'aide d'un dispositif d'accrochage de germe (24), et dans laquelle l'installation de croissance de cristaux comprend une cavité de germe disposée entre le monocristal (4) et le couvercle de creuset à l'intérieur du creuset de croissance,
dans laquelle la surface du dispositif d'accrochage de germe (24) adjacente à la cavité de germe présente de préférence une quatrième émissivité (ε) prédéterminée, et/ou la surface du couvercle de creuset adjacente à la cavité de germe présente de préférence une cinquième émissivité (ε) prédéterminée, et/ou la surface du monocristal (4) adjacente à la cavité de germe présente de préférence une sixième émissivité (ε) prédéterminée,
et/ou
dans laquelle la surface du couvercle du creuset adjacente à la cavité de germe et/ou la surface du dispositif d'accrochage de germe (24) adjacente à la cavité de germe et/ou la surface du monocristal (4) adjacente à la cavité de germe présente de préférence un autre relief prédéterminé (29),
et/ou
dans laquelle la cavité de germe est de préférence remplie d'une matière solide, la matière solide étant constituée de poudre de SiC, d'un cristal de SiC polycristallin ou monocristallin, et/ou de graphite poreux ou massif.

6. Installation de croissance de cristaux selon l'une des revendications précédentes,
l'installation de croissance de cristaux comprenant un dispositif de chauffage pour chauffer le creuset de croissance, le dispositif de chauffage comprenant de préférence une unité de chauffage inductif (6) et/ou une unité de chauffage par résistance (9),
le dispositif de chauffage étant de préférence disposé entre le fond de creuset et la première isolation thermique (5) et/ou entre la paroi latérale de creuset et la première isolation thermique (5).

7. Installation de croissance de cristaux selon l'une des revendications précédentes,
l'installation de croissance de cristaux comprenant un premier (14) et/ou un deuxième (15) accès pyrométrique,
le premier accès pyrométrique (14) traversant la deuxième isolation thermique (12) jusqu'au couvercle de creuset, de préférence le long de l'axe de rotation du creuset de croissance, et/ou
le deuxième accès pyrométrique (15) traversant la première isolation thermique (5) et/ou le dispositif de chauffage jusqu'au fond de creuset, de préférence le long de l'axe de rotation du creuset de croissance.

8. Installation de croissance de cristaux selon l'une des revendications précédentes,
dans laquelle la première isolation thermique (5) est disposée directement ou indirectement au-dessus d'une surface annulaire radialement extérieure du couvercle de creuset,
et/ou
dans laquelle le fond de creuset, la paroi latérale de creuset et/ou le couvercle de creuset du creuset de croissance est formé de graphite et/ou de TaC et/ou de graphite revêtu, en particulier de graphite revêtu de carbone par pyrolyse et/ou de graphite revêtu de Ta et/ou de TaC.

9. Installation de croissance de cristaux selon l'une des revendications précédentes,
dans laquelle le matériau source (2) peut être évaporé et/ou transporté et/ou déposé dans le creuset de croissance en fonction de gradients de température, les gradients de température étant réglables de manière ciblée dans le creuset de croissance.

10. Installation de croissance de cristaux selon l'une des revendications précédentes,
l'installation de croissance de cristaux étant conçue pour le réglage ciblé de gradients de température dans le creuset de croissance,
les gradients de température étant réglables par la configuration de la première (5) et/ou de la deuxième isolation thermique (12) de telle sorte que les isothermes (7) présentent une allure convexe.

11. Installation de croissance de cristaux selon l'une des revendications précédentes,
dans laquelle les gradients de température dans le creuset de croissance sont réglables par le dispositif de chauffage.

12. Installation de croissance de cristaux selon l'une des revendications précédentes,
dans laquelle la première isolation thermique (5) est constituée d'un premier matériau d'isolation, en particulier d'un premier matériau d'isolation à haute température, ou présente un tel matériau, de préférence un matériau solide, de manière particulièrement préférée un feutre de graphite et/ou une mousse de graphite, et/ou
dans laquelle la deuxième isolation thermique (12) est constituée d'un deuxième matériau d'isolation, en particulier d'un deuxième matériau d'isolation à haute température, ou présente un tel matériau, de préférence un matériau solide, de manière particulièrement préférée de la mousse de graphite et/ou du graphite poreux.

13. Installation de croissance de cristaux selon l'une des revendications précédentes,
dans laquelle la deuxième isolation thermique (12) est formée d'une succession de plusieurs plaques (33) respectivement espacées les unes des autres, les plaques (33) étant de préférence en forme de disque circulaire, et/ou dans laquelle la deuxième isolation thermique (12) est de préférence formée de deux à dix, de préférence de trois à cinq, plaques (33), et/ou dans laquelle les plaques (33) sont de préférence formées d'un matériau stable à haute température,
le matériau stable à haute température étant de préférence du graphite, du graphite revêtu, du carbure métallique et/ou du métal à haute température de fusion, et/ou
dans laquelle les plaques (33) ont de préférence chacune une épaisseur comprise entre 0,1 et 10 mm, de manière particulièrement préférée entre 0,5 et 3 mm, et/ou
dans laquelle les plaques successives (33) présentent de préférence chacune une distance comprise entre 1 et 50 mm, de manière particulièrement préférée entre 5 et 20 mm, et/ou
dans laquelle les plaques (33) présentent de préférence chacune plusieurs entailles longitudinales (39).

14. Installation de croissance de cristaux selon la revendication 13,
dans laquelle les plaques (33) présentent sur leurs surfaces une émissivité réglée de manière définie, de préférence une émissivité d'au plus 0,4 ou une émissivité d'au moins 0,6, de manière particulièrement préférée une émissivité d'au plus 0,3 ou une émissivité d'au moins 0,7,
dans laquelle les émissivités de plaques (33) successives sont de préférence différentes, et/ou dans laquelle les émissivités sur une face inférieure et sur une face supérieure d'une ou plusieurs plaques (33) sont de préférence différentes.

15. Procédé de production et/ou d' agrandissement d'un monocristal (4) par chauffage, évaporation et dépôt d'un matériau source dans le creuset de croissance d'une installation de croissance de cristaux selon l'une quelconque des revendications 1 à 14,
le matériau source (2) étant évaporé et/ou transporté et/ou déposé en fonction de gradients de température, les gradients de température étant réglés de manière ciblée,
le creuset de croissance présentant un fond de creuset, une paroi latérale de creuset et un couvercle de creuset, la paroi latérale de creuset étant entourée directement ou indirectement par une première isolation thermique (5) ayant une première conductivité thermique, une deuxième isolation thermique (12) ayant une deuxième conductivité thermique étant disposée directement ou indirectement au-dessus du couvercle de creuset, la deuxième conductivité thermique étant supérieure à la première conductivité thermique, la deuxième conductivité thermique étant située dans une plage de 2 à 50 W/(m*K) à température ambiante, et
les gradients de température étant réglés par la conception de la première et/ou de la deuxième isolation thermique (12) de telle sorte que les isothermes (7) présentent une allure convexe.
